(19) Europäisches Patentamt
European Patent Office
Office européen des brevets

(11) **EP 4 285 145 B1**

(12) **EUROPEAN PATENT SPECIFICATION**

(45) Date of publication and mention
of the grant of the patent:
**29.04.2026 Bulletin 2026/18**

(21) Application number: **22706090.2**

(22) Date of filing: **01.02.2022**

(51) International Patent Classification (IPC):
**G01S 7/4865** *(2020.01)*  **G01S 7/487** *(2006.01)*
**G01S 17/10** *(2020.01)*  **H03M 7/30** *(2006.01)*

(52) Cooperative Patent Classification (CPC):
**G01S 17/10; G01S 7/4866; G01S 7/487;**
**H03M 7/3059**

(86) International application number:
**PCT/GB2022/050263**

(87) International publication number:
**WO 2022/162404 (04.08.2022 Gazette 2022/31)**

(54) **SENSOR DEVICE FOR IMAGING**

SENSORVORRICHTUNG FÜR BILDGEBUNG

DISPOSITIF CAPTEUR POUR IMAGERIE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **01.02.2021 GB 202101369**

(43) Date of publication of application:
**06.12.2023 Bulletin 2023/49**

(73) Proprietor: **The University Court Of**
**The University of Edinburgh**
**Edinburgh EH8 9YL (GB)**

(72) Inventors:
• **DAVIES, Michael**
**Edinburgh EH9 3FG (GB)**
• **TACHELLA, Julian Andrés**
**Edinburgh EH9 3FG (GB)**
• **SHEEHAN, Michael P**
**Edinburgh EH9 3FG (GB)**

(74) Representative: **Marks & Clerk LLP**
**15 Fetter Lane**
**London EC4A 1BW (GB)**

(56) References cited:
**JP-A- 2016 161 438  US-A1- 2018 209 846**

• **MOCHIZUKI FUTA ET AL: "Separation of Multi-path Components in Sweep-less Time-of-flight Depth Imaging with a Temporally compressive Multi-aperture Image Sensor", ITE TRANSACTIONS ON MEDIA TECHNOLOGY AND APPLICATIONS, vol. 6, no. 3, 1 July 2018 (2018-07-01), pages 202 - 211, XP055916088, ISSN: 2186-7364, Retrieved from the Internet <URL:https://www.jstage.jst.go.jp/article/mta/6/3/6_202/_pdf/-char/en> [retrieved on 20220426], DOI: 10.3169/mta.6.202**

## Description

### Field

The present invention relates to a sensor device, for example a sensor device suitable for use in imaging applications, in particular, time of flight imaging.

### Background

Single photon lidar based on the principle of time of flight (ToF) has become a prominent tool for high-speed ToF imaging in recent years. At the core of the technique, the depth of an object of interest is measured directly through time-correlated single-photon counting data or by constructing a histogram of time delays.

The development of high rate, high resolution, low-power ToF image sensors is challenging due to large data volumes required. This may cause a major data processing bottleneck on the device when either the number of photons per pixel is large, the time resolution is fine or the spatial resolution is high, as the space requirement, power consumption and computational burden of the depth reconstruction algorithms scale with these parameters.

Known methods to mitigate data transfer issues include, for example: direct calculation of a depth from SPAD pulses; embedded histogram processing to estimate the histogram peak position; motion triggered in-pixel histograms; range-gating histograms, and discarding photon detections based on activity. These techniques may compromise, for example, computation, accuracy, or resolution to achieve reduced data rates which may limit their effectiveness.

Compressed sensing (CS) is a set of techniques that have been proposed to reduce the number of acquisitions (measurements) in sensing applications. Compressed sensing has been applied to MRI and in optical imaging. Known compressed sensing imaging solutions have been proposed but are based on spatial encoding or spatial temporal encoding (i.e. video) of the 2d or 3d image measurements. Compressive Learning (CL) is an extension of CS that generalizes CS theory to machine learning problems and the "measurement" and reconstruction of probability distributions. CL may be performed through a collection of "random" statistics including the random Fourier features, which are popular in machine learning. To date, known applications of CL may be found in machine learning, distributed machine learning and privacy-based machine learning.

JP 2016 161438 describes a histogram generation means that adds the measurement value obtained at a predetermined detection time by repeating the time measurement to the time bin, and integrates the time and the measurement value. Mochizuki Fute et al. "Separation of Multi-Path Components in Sweepless Time-of-flight Depth Imaging with a Temporally compressive Multi-aperture Image Sensor" describes separating multi-path components caused by specular reflection with temporally compressive time-of-flight (CToF) depth imaging. US 2018/209846 describes modulating the sensitivity of a single-photon avalanche diode (SPAD) detector over time.

### Summary

Aspects of the invention are in accordance with the appended independent claims.

In accordance with a first aspect there is provided a sensor device for photon-based imaging comprising: one or more photon detectors configured to produce a plurality of photon detection signals in response to a plurality of photon detection events, wherein each photon detection event has a corresponding detection time and wherein the detection times of the plurality of photon detection events are distributed in accordance with a distribution overtime, wherein the photon detection events correspond to detection of photons produced by an illumination source associated with the sensor device and subsequently scattered and/ or reflected and/or transmitted over a detection time period; processing circuitry associated with the one or more photon detectors configured to obtain timing information of the plurality of photon detection events; and further processing circuitry configured to and to perform a sketching process using the timing information of the plurality of photon detection events to obtain a compressed representation of the distribution over time, wherein the sketching process comprises: generating a plurality of feature values based on the timing information of the plurality of photon detection events using one or more feature functions; combining the generated plurality of feature values to obtain the compressed representation of the distribution over time, wherein the feature functions have one or more properties such that combining the plurality of feature values generated using the one or more feature functions preserves signal information and/or suppresses background information and/or distinguishes signal information from background information in the compressed representation, wherein the compressed representation is such that at least one or more desired parameters of the distribution over time can be estimated by performing a parameter estimation process using the compressed representation, wherein the parameter estimation process is based on a model of the distribution over time, wherein the one or more feature functions are dependent on at least time and are continuous.

Each photon detector may comprise a single photon avalanche diode (SPAD). The compressed representation may be referred to as a sketch. The compressed representation may comprise sufficient information to provide an estimate of one or more parameters of the distribution over time. The compressed representation may be such that storage and/or transmission of the compressed representation uses less storage capacity and/or communication capacity than storage and/or transmission of the plurality of photon detection event signals and/or a histogram-based representation of the distribution over time. The compressed representation may be such that obtaining the compressed representation uses less computational resources than obtaining a histogram-based representation of the distribution over time. The compressed representation may be such that performing the parameter estimation process uses less computational resources than estimating the desired parameters from the plurality of photon detection event signals and/or a histogram-based representation.

The sensor device may be for use in an imaging process in which a scene comprising one or more targets is imaged and the distribution over time may be dependent on the scene being imaged. The scene being imaged may contain a number of targets and the size of the compressed representation may scale with at least the number of targets in the scene, per-pixel.

The plurality of photon detection events may comprise signal and background photon detection events. The signal photon detection events may correspond to detection of scattered and/or reflected and/or transmitted photons. The signal photon detection events may correspond to detection of photons produced by an illumination source associated with the sensor device and subsequently scattered and/or reflected and/or transmitted. The plurality of feature values produced by the sketching process may comprise signal and background feature values corresponding to feature values produced by signal photon detection events and background photon detection events, respectively.

The compressed representation is such that the storage capacity and/or communication capacity required by the compressed representation does not depend on the number of photon detection events and/or a detection time resolution. The distribution over time may comprise a time-delay distribution.

The one or more feature functions may be based on an expected background distribution of the photon detection events.

The one or more feature functions may comprise a functional form such that, when combining the feature values, the feature values associated with background photon detection events substantially cancel to provide a zero or at least substantially supressed contribution to the compressed representation.

The substantially supressed contribution may be relative to a corresponding contribution to the combination from feature values associated with signal photon detection events.

The one or more feature functions may comprise a mapping of timing information to a phase representation so that the feature values are representative of a phase, such that, when the feature values are combined, the phases for background events substantially cancel.

The one or more feature functions may comprise at least one of: a non-linear function, a periodic function, a continuous function. The one or more feature functions may be dependent on at least time.

The one or more feature functions may comprise a set of: periodic triangular functions, harmonic periodic functions, periodic complex representations. The one or more feature functions may produce non-zero valued feature values and/or wherein combining the feature values uses feature values obtained from each of the plurality of photon detection events.

The one or more feature functions may comprise at least one of: a polynomial function; a piecewise polynomial function; a spline function.

The feature functions may comprise or be configured to be formed from a set of basis functions. The basis functions may comprise spline or polynomial functions or sinusoidal functions. Using the one or more feature functions may comprise approximating the feature functions using the set of basis functions, for example, by forming a linear combination of their output. The set of basis function may comprise polynomial or spline functions or sinusoidal functions.

The set of basis functions may have one or more properties that allow a compressed representation to be formed using their output, for example, values generated using the set of basis functions. The one or more properties include: the set of polynomial basis functions may be combined to form an approximation of a sinusoidal function or other periodic, non-linear function; each basis function may comprise a local portion centred on a respective time; the respective times may correspond to regular time intervals across a time window; the respective times may correspond to irregular time intervals across the time window; the local portion of each basis function may overlap in time with one or more of the other basis functions; the local portion may be periodic; the local portion may comprise a polynomial function. At least one basis function may comprise an increasing portion over an interval of time and at least one other basis function may have a decreasing portion over said interval of time. The local portion may be non-zero over a time interval.

The sketching process and/or the parameter estimation process may comprise combining feature values generated by the set of basis functions, for example, a linear combination of feature values.

The photon detection events may occur over a pre-determined detection time period. The one or more feature function may comprise a periodic function characterised by a frequency that is a multiple of the inverse of the pre-determined detection time period. The frequency may be an integer multiple of the inverse of the pre-determined detection time period.

The sketching process comprises selecting more than one frequency for the one or more feature functions in accordance with a frequency-selection scheme. The sketching may further comprise generating feature values and combining said feature values for each selected frequency. The compressed representation may comprise at least one total value for each frequency. The compressed representation may be characterised by a sketch size. The sketch size may correspond to at least the number of frequencies selected, preferably twice the number of frequencies selected.

The selection of the frequency may be such that combining feature values generated by the sketching function at each of the selected frequencies suppresses the background information. The frequencies may be selected in accordance with a random distribution. A first pre-determined number of frequencies from a set of frequencies may be selected. A frequency equal to zero is selected to provide information related to the number of photon detection events.

The timing information may comprise a representation of the detection time of each photon detection event signal. The timing information may comprise a count of photon detection events in one or more pre-determined timing intervals. The sketching process may comprise obtaining one or more feature values from the one or more feature functions using the detection time of each photon detection event signal thereby to obtain the plurality of feature values. The processing circuitry may be configured to obtain a histogram-based representation of the timing information and performing the sketching process on the histogram-based representation.

The processing circuitry may be further configured to obtain at least one feature value for the one or more feature functions, dependent on the timing information.

Obtaining the feature values may comprise retrieving a value from a look-up table and/or performing a feature value generating algorithm, for example, digit-by-digit algorithm or CORDIC algorithm.

The device may further comprise processing circuitry associated with the one or more photon detectors. The processing circuitry may be configured to process the plurality of produced photon detection signals to produce a plurality of photon detection event signals. Each photon detection event signal may comprise time data representative of the detection time at which the photon detection event occurred.

Combining the plurality of the feature values may comprise storing a running total or average of the feature values and updating the running total or average using a new feature value in response to a photon detection event. At least one running total or average of the feature values may be stored and/or updated per selected frequency.

The running total or average may be represented by an intermediate compressed representation. The intermediate compressed representation may be stored and/or updated in response to a photon detection event.

The device may comprise a memory resource for storing the compressed representation and/or a communication interface for communication of the compressed representation to a further device.

The model of the distribution over time may be based on a photon time-of-flight observation model. The model of the distribution over time may comprise a first portion associated with signal photon detection events and a second function associated with background photon detection events. The model of the distribution over time may comprise a first portion representative of an expected distribution of signal photon detection events and/or a second portion representative of an expected distribution of background photon detection events.

The model of the distribution over time may comprise a model based on an impulse response function or an empirical approximation of the impulse response function. The model of the distribution over time may comprise a portion based on a Poisson distribution. The model of the distribution over time may comprise at least one Gaussian portion for the signal photon detection events. The model of the distribution over time may comprise a portion representative of background photon detection event. The model of the distribution over time may comprise a uniform distribution for the background photon detection events. The model of the distribution over time may comprise a first portion based on a model of an expected distribution of signal photon detection events and a second portion based on model of an expected distribution of background photon detection events.

The one or more desired parameters may comprise a measure of distance between the sensor device and a target in a scene and/or a measure of intensity of reflection of light by a target. The parameter may comprise a count of photon detection events.

The model of the distribution over time may comprise at least a portion that is dependent on intensity. One or more properties of the model of the distribution over time may be selected based on intensity.

The one or more parameters may be estimated from the compressed representation by performing a mathematical optimization process using the compressed representation.

The processing circuitry may be further configured to perform the parameter estimation process on the compressed representation thereby to determine an estimate for the one or more desired parameters.

The device may further comprise a communication resource for communicating the determined estimates to a further computing resource.

In accordance with a second aspect, there is provided an imaging system comprising the sensor device provided in accordance with the first aspect and an illumination source.

In accordance with a third aspect, which may be provided independently, there is provided a method comprising: performing a sketching process using timing information of a plurality of photon detection events, wherein each photon detection event has a corresponding detection time and wherein the detection times of the plurality of photon detection events are distributed in accordance with a distribution over time, to obtain a compressed representation of the distribution over time, wherein the photon detection events correspond to detection of photons produced by an illumination source associated with the sensor device and subsequently scattered and/or reflected and/or transmitted over a detection time period and wherein the sketching process comprises: obtaining timing information of the plurality of photon detection events;generating a plurality of feature values based on the timing information of the plurality of photon detection events using one or more feature functions; combining the generated plurality of feature values to obtain the compressed representation of the distribution over time, wherein the one or more feature functions have one or more properties such that combining the plurality of feature values generated using the one or more feature functions preserves signal information and/or suppresses background information and/or distinguishes signal information from background information in the compressed representation, wherein the compressed representation is such that at least one or more desired parameters of the distribution over time can be estimated by performing a parameter estimation process using the compressed representation, wherein the parameter estimation process is based on a model of the distribution over time, wherein the one or more feature functions are dependent on at least time and are continuous.

In accordance with a fourth aspect there is provided a non-transitory computer readable medium comprising instructions operable by a processor to perform the method of the third aspect.

In accordance with a fifth aspect, which may be provided independently, there is provided a sensor device for photon-based imaging, comprising: one or more photon detectors configured to produce a plurality of photon detection signals in response to a plurality of photon detection events, wherein each photon detection event has a corresponding detection time and wherein the detection times of the plurality of photon detection events are distributed in accordance with a distribution over time; and processing circuitry configured to perform a process, for example, a sketching process, using timing information of the plurality of photon detection events to obtain a compressed representation of the distribution over time. The process may comprise: generating a plurality of feature values based on the timing information of the plurality of photon detection events using one or more feature functions. The sketching process may further comprise combining the generated plurality of feature values to obtain the compressed representation of the distribution over time.

The feature functions may comprise a set of basis functions. The set of basis functions may comprise spline or polynomial functions or sinusoidal functions. At least two of the one or more feature functions may have non-zero portions that overlap in time. The one or more feature functions may comprise a set of functions such that at least two of the one or more feature functions have a non-zero value over at least part, optionally all of a time window. At least one basis function may comprise an increasing portion over an interval of time and at least one other basis function may have a decreasing portion over said interval of time.

The set of basis functions may have one or more properties that allow a compressed representation to be formed using the generated feature values. The one or more properties include: the set of basis functions may be combinable to form an approximation of a sinusoidal function or other periodic, non-linear function; each basis function may comprise a local portion centred or associated with a respective time; the local portion of each basis function may overlap in time with one or more portions of the other basis functions; the local portion may be periodic; the local portion may be polynomial.

Each basis function may comprise a local portion centred or associated with a respective time. The respective times of each basis function may correspond to regular time intervals across a time window. The respective times of each basis function may correspond to irregular time intervals across the time window. The one or more feature functions may comprise one or more functions locally centred at one or more times.

The compressed representation may preserve signal information and/or supress background information and/or distinguishes signal information from background information in the compressed representation. The compressed representation may be such that at least one or more desired parameters of the distribution over time may be estimated by performing a parameter estimation process using the compressed representation. The parameter estimation process may be based on a model of the distribution over time. The process and/or the parameter estimation process may comprise combining feature values generated by the set of basis functions, for example, a linear combination of feature values.

In accordance with a sixth aspect, which may be provided independently, there is provided a method comprising: performing a process, for example, a sketching process, using timing information of a plurality of photon detection events, wherein each photon detection event has a corresponding detection time and wherein the detection times of the plurality of photon detection events are distributed in accordance with a distribution over time, to obtain a compressed representation of the distribution over time. The process may comprise: generating a plurality of feature values based on the timing information of the plurality of photon detection events using one or more feature functions. The process may comprise combining the generated plurality of feature values to obtain the compressed representation of the distribution over time.

In accordance with a seventh aspect there is provided a non-transitory computer readable medium comprising instructions operable by a processor to perform the method of the sixth aspect.

There may be provided a method, system or device substantially as described herein with reference to the accompanying drawings.

Features in one aspect may be provided as features in any other aspect as appropriate. For example, features of a method may be provided as features of an apparatus and vice versa. Any feature or features in one aspect may be provided in combination with any suitable feature or features in any other aspect.

**Brief Description of Drawings**

Various aspects of the invention will now be described by way of example only, and with reference to the accompanying drawings, of which:

Figure 1 is a schematic diagram of an imaging system comprising a sensor device and an illumination source;
Figure 2 is a schematic diagram showing in overview the sensor device, according to an embodiment;
Figure 3 is a schematic diagram illustrating a sketching process;
Figure 4 is a flow-chart of a method of obtaining a compressed representation using the sensor device;
Figure 5 is a schematic diagram showing in overview a sensor device according to a further embodiment;
Figure 6 is a schematic diagram illustrating a further sketching process;
Figure 7 is a plot of a distribution of photon detection events showing estimates of parameters of said distribution;
Figure 8(a) is a plot illustrating a measured error for a compressed representation method and Figure 8(b) is a plot of the percentage of peak detected as a function of the time stamp resolution for a compressed representation method;
Figures 9(a) and 9(b) are plots of a characteristic function and a data driven response function for a first and second data set;
Figure 10 is a plot illustrating a measured error for a compressed representation method;
Figures 11(a) and 11(b) are plots illustrating lidar reconstructions for a first data set and a second data set, and
Figures 12(a) and 12(b) are plots illustrating sets of spline functions.

**Detailed Description of the Drawings**

Embodiments described in the following may address the bottleneck of known time of flight based imaging techniques, for example lidar techniques, by calculating a compressed representation, which may also be referred to as a sketch, of a time distribution of photon detection events. In particular, rather than construct and transfer a full time distribution of arrival times of photons (for example, a histogram) a compressed representation is generated for storage or transfer. As described in further detail in the following, the compressed representation provides on-the-fly summary statistics of the photon time stamps, based on samples of a characteristic function of a time distribution.

A number of advantages may be provided by the following embodiments. For example, the size of the sketch may scale with the number of degrees of freedom of the time of flight (ToF) model (for example, this may be the number of objects in the scene) rather than the number of photons or the fineness of the time resolution. This scaling may be possible without sacrificing precision in depth. The sketch may be computed for each incoming photon in an online fashion, only requiring a minimal amount of additional computation which can be efficiently performed in-chip. The sketch has sufficient information to provide an estimate of one or more parameters of the underlying distribution. It may be shown that the sketch captures all the salient information of the histogram, including the ability to compensate for background light or dark count effects, in a compact and data efficient form, suitable for either in-chip processing or for efficient data transfer for subsequent off-chip post processing.

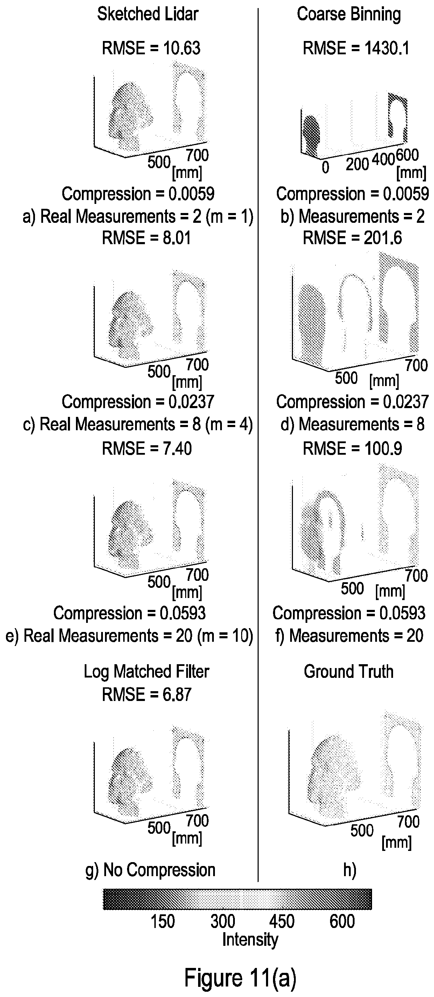

Furthermore, embodiments allow off-chip image reconstruction algorithms to be developed in which the computational complexity is dependent on the size of the sketch. It has been found that, for some embodiments, resources used for data transfer may be reduced by up to and more than 30 times over transferring individual photon timing information or histogram counts while retaining almost full statistical efficiency. In the case of a simple two-component sketch (using polystyrene head data, as discussed with reference to, for example, Figure 11(a)) the compression was found to be approximately 160 times. The embodiments described in the following may allow for high accuracy 3D imaging at fast frame rates and with low power consumption.

Embodiments described in the following, aim to acquire a compressed set of statistics. The compressed set of statistics may be, for example, Fourier series (FS) measurements of a photon arrival times over a set of pulses separately per pixel. From these statistics the reflection distances measured at each pixel can be calculated making use of the known SPAD temporal response function. Working per pixel makes separable processing possible and allows for low complexity acquisition that may be included on the back of the imaging pixel.

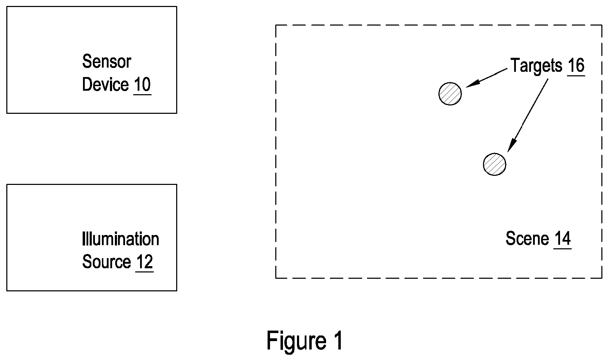

Figure 1 is a schematic representation of an imaging system comprising a sensor device 10 and an illumination source 12, for example, a laser, provided in accordance with an embodiment. It will be understood that the sensor device 10 can be provided separately from the illumination source 12. Furthermore, while described in the context of a lidar imaging system, it will be understood that the sensor device 10 may be used in other contexts.

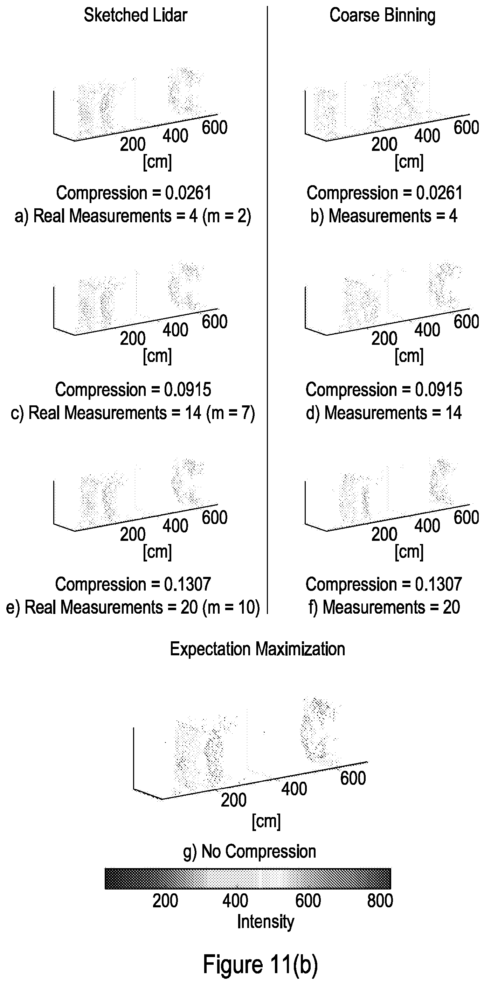

The lidar based imaging system of Figure 1 operates by the illumination source 12 illuminating a scene 14 of an environment to be imaged. The scene 14 contains a number of targets 16 to be imaged. For simplicity, the targets are 16 depicted in Figure 1 as point-like targets, however, it will be understood that in practice, the targets may be complex having more than one extended surface and/or having specific transmission/reflection properties. As a non-limiting example, a first target could be a transparent window and a second target an object having more than one reflective surface behind the window. Examples of data sets that have been used are discussed in further detail in the following, for example, with reference to Figure 11(a) and 11(b).

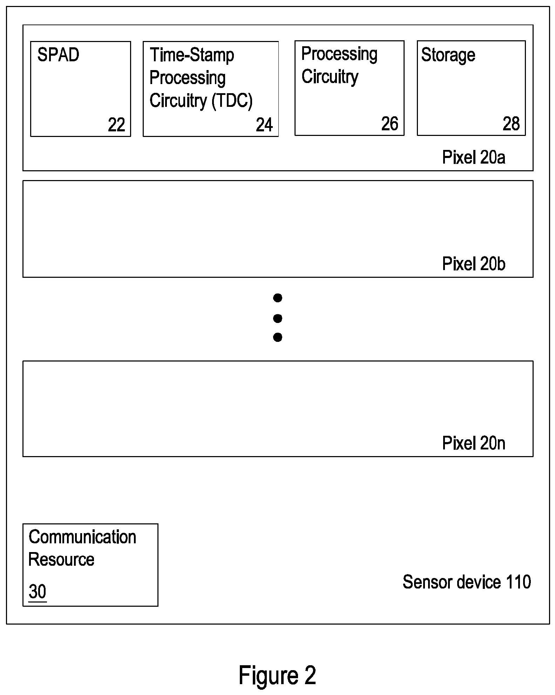

Following illumination of the scene 14 by the illumination source 12, light is detected by the sensor device 10. As described in further detail with reference to Figure 2, the sensor device 10 detects both signal and background photons arriving from the scene 14. The signal photons substantially correspond to photons first emitting by illumination source 12 and then reflected by surfaces of the targets 16. The background photons correspond to photons originating from other sources, for example, ambient or environmental light.

In known lidar-based imaging systems, the sensor device 10 produces data allowing a histogram of the arrival times of photons to be constructed. The histogram is representative of a time distribution of detected photons. In general, peaks of the histogram correspond to signal photons such that the location of a peak of the histogram can be used to determine a measure of distance between the sensor device 10 and the targets 16, allowing an image of the scene to be reconstructed. In contrast to known lidar-based imaging systems, and as described in further detail in the following, a sensor device 10 provided in accordance with embodiments is not configured to determine the full histogram representative of the time distribution but rather to generate a compressed representation of the time distribution. In other embodiments, the sensor device may first generate the full histogram and, rather than transfer the full histogram off the device, may form a compressed representation of the full histogram such that only the compressed representation is transferred off the device.

Turning to Figure 2, a schematic diagram of the sensor device is provided. For brevity the sensor device 10 may also be referred to as a sensor 10. The sensor 10 has a plurality of pixel devices 20a, 20b, ... 20n, provided as part of a pixel array. The pixel devices 20a, 20b, ... 20n may also be referred to as pixels. For clarity, only the components of the first pixel device 20a are described in the following and it will be understood that the other pixel devices 20b, ... 20n of the pixel array have components corresponding to those described with reference to pixel device 20a.

Pixel device 20a has a photon detector, in the present embodiment, the photon detector is a single SPAD 22. Associated with the SPAD 22 is dedicated time-stamp processing circuitry 24, for example a Time to Digital Converter (TDC) and processing circuitry 26. The SPAD 22 is configured to produce photon detection signals in response to photon detection events. The TDC 24 processes the photon detection signals and provides photon detection event signals, for example in the form of time stamp data, digital timing signals or other representation of the time an event occurs. The processing circuitry 26 is provided per pixel to process photon detection event signals to perform a sketching process using the photon detection event signals.

In the presently described embodiment, each pixel device, for example, pixel 20a, has a single SPAD. However, it will be understood that in other embodiments, each pixel device has a SPAD array comprising a plurality of SPADs.

In some embodiments, the processing circuitry 26 is provided per pixel. In other embodiments, the processing circuitry 26 is provided as a shared component, for example, the processing circuitry or part of the processing circuitry is provided as part of a further processing resource configured to process photon detection event signals received from more than one or all pixels. In some embodiments, the TDC or at least some components of a TDC is shared between pixels. In such embodiments, timestamps or other timing information for a plurality of pixels may be generated by a common TDC or by TDCs sharing at least some common components.

The sensor 10 also includes a communications resource 28 in the form, in this embodiment, of a sensor output bus. The sensor output bus enables transmission of data from the sensor 10 to an external processing resource (not shown in Figure 2).

With reference to the SPAD 22, a time of arrival of a single photon is registered as a change in state of the SPAD, for example from an un-activated state to an activated state. Following activation, the SPAD has an intrinsic dead-time period that typically lasts 10s of nanoseconds. After the dead time period has expired the SPAD resets to its original, un-activated state.

As described above, contrary to known systems, rather than use the photon detection signals to produce a full representation of a time distribution for detected photons, a compressed representation, which may also be referred to as a sketch is produced. The processing circuitry 26 is configured to perform the sketching process. As part of the sketching process, the processing circuitry 26 is configured to obtain one or more values, herein referred to as feature values, using one or more feature functions.

The processing circuitry 26 may obtain output values from the feature values using different methods. In the present embodiment, the processing circuitry 26 calculates feature values using the detection time in accordance with any suitable algorithm. A non-limiting example of a suitable algorithm is a CORDIC algorithm.

The plurality of feature values are returned at a high rate, in the present embodiment, and this may be performed using an appropriate approximation of the feature function. In the present embodiment, the compressed representation is calculated by taking the running total (or an average) of multiple nonlinear functions of the detection time, $t_D$, i.e. the

trigonometric functions: $\sin(\omega_i t_D)$ or $\cos(\omega_i t_D)$ are used for a range of m frequencies, $w_i = \omega_1, ..., \omega_m$. These functions may be computed at a very high rate and in practice may be computed only approximately.

In other embodiments, a readable memory resource (not shown in Figure 2) for storing feature values for detection times is provided. This can be in the form of, for example, a look-up table. In such embodiment, the processing circuitry 26 is configured to obtain feature values for a detection time by retrieving feature values from the look-up table. In further detail, a plurality of feature values for the feature function is returned in response to a request from the processing circuitry 26 that comprises the detection time information (for example, in the form of time stamp data). The storage resource look-up table can be provided per-pixel or as a shared resource between more than one pixel. The processing resource 26 and/or the readable memory resource can be provided as either FPGA or ASIC hardware.

Regarding the feature function, the following comments regarding the feature function are provided. Further comments regarding the theoretical background and feature function are provided later in the specification. The one or more feature functions have a number of properties that allow for a compressed representation that provides sufficient information for the determination of parameters of the underlying time distribution.

In the present embodiment, a single, multivariate feature function is described that outputs a plurality of feature values. The single, multivariate feature function is a function of both time and frequency. It will be understood that such a single, multivariate feature function can equivalently be represented as a group of functions i.e. a group of time dependent functions at different frequencies. In the present embodiment, the equivalent group of functions are sinusoidal functions $\sin(\omega_i t_D)$ or $\cos(\omega_i t_D)$ for $\omega_i = \omega_1, ..., \omega_m$.

In further detail, in the present embodiment, the multi-variate function is representative of a mapping between detection time $t_D$ and frequency $\omega_i$ for a range of frequencies. For a single frequency $\omega_i$, the multi-variate function maps detection time to two real output values $\sin(\omega_i t_D)$ and $\cos(\omega_i t_D)$. In further detail, for each frequency, the multi-variate function maps the detection time to the two real output values, and therefore, for m frequencies, the multi-variate function maps the time to 2m real values. It will be understood that, for a particular frequency, the output can be represented as a two-component vector or as a complex number. For a choice of m frequencies, the multi-variate feature function maps detection time onto 2m real output values $\sin(\omega_i t_D)$ or $\cos(\omega_i t_D)$ for $\omega_i = \omega_1, ..., \omega_m$. The output from the multi-variate function is represented by a feature vector, in this case, as a 2m component vector where each component is a real number. Other representations of the feature vector are possible, for example, the feature vector could be represented as m complex values components.

While trigonometric functions are described above, these are provided as an example of a suitable non-linear, continuous and periodic function that can be used as part of the sketching process. It will be understood that other feature functions with similar properties, for example, non-linear periodic functions can be used. Other transforms, for example, triangular waves of different frequencies or structured time-domain transforms, may provide suitable properties. Other functions are suitable. For example, periodic triangular or square functions can be used. In addition, any harmonic periodic functions (where the harmonic is defined with reference to a time gated window) or a periodic complex representation may be suitable. The feature functions may be considered as mapping timing information to a phase representation such that when the feature values are combined, the phases for background events substantially cancel.

In particular, the one or more feature functions are such that the output of the one or more feature functions, the feature values, corresponding to signal photon detection events provide a larger contribution to the compressed representation than output of the one or more feature functions corresponding to background signal events. As described in the following, in some embodiments, the feature function also has the property that the sketching process includes selecting frequencies for the feature function such that the expected value for background photon detection events is substantially zero.

It will be understood that while different representation for the one or more feature functions may be suitable, the feature functions have properties such that the combination of their output i.e. the plurality of feature values, preserves signal information and/or supresses background information and/or distinguishes signal information from background information in the compressed representation.

In further embodiments, the feature functions may be a polynomial function or a piecewise polynomial function or a spline function. The feature functions may be a piecewise low order approximation of a sinusoidal function.

The one or more feature functions are time-dependent, and therefore the feature values obtained by the processing circuitry 24 depend on the detection time of the photon detection event. As the one or more feature functions either comprise a function that is dependent on frequency or a group of functions characterised by different frequencies, part of the sketching process requires a selection of one or more frequencies for the one or more feature functions. It has been found that particular choices of frequencies may provide additional advantages. In particular, for a pre-determined detection time period and where the one or more feature function is a periodic function characterised by a frequency, a suitable choice of frequency is a multiple of the inverse of the pre-determined detection time period.

In further detail, it is known to introduce a time window over which photon detection occurs (in lidar this is referred to as *time gating*). The time window may also be referred to as the acquisition time or detection time. The selected frequencies are dependent on the size of this time window, duration T, using trigonometric functions with frequencies that are a harmonics of $1/T$. Using such frequencies for the one or more feature functions allows the combination of outputs to be "blind" to the background count. This provides a sketch that can be used to estimate range and reflectivity without considering the background count. In the simplest case, discussed in the theoretical background section, a sketch of size 2 is used to calculate the "circular mean" to calculate a single range.

In particular, selection of frequencies that correspond to the set of Fourier components of with frequencies that are a harmonics of $1/T$ provides sample values that are zero for background photon detection events. Therefore, this choice of frequencies eliminates the expected contribution to the compressed representation from background photon detection events to zero. In other embodiments, choices of frequency substantially supress the contribution to the compressed representation. There is a freedom in the choice of which frequencies to use. In one non-limiting example, the first m complex trigonometric functions over a time gated window are used. In a further non-limiting example, a set of trigonometric functions with harmonic frequencies are chosen. The choice of a larger set of trigonometric functions i.e. using a larger number of selected frequencies, allows a compressed representation for a more complex distribution over time to be determined. Further discussion regarding the selection of frequencies is provided in the following and in the theoretical background section.

While a selection of frequencies that allow construction of a compressed representation that is blind to the background, in some embodiments, background information should be retained. In such embodiments, the total photon count is calculated and stored. For a suitable choice of feature function, this count corresponds to the zero component frequency. This may be used, for example, in conjunction with the background blind sketch for the detection of the absence/presence of one or more targets, or to improve the range and refection estimation.

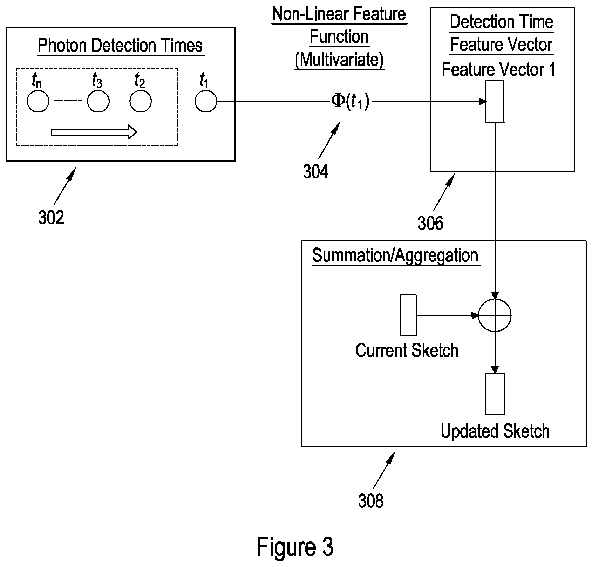

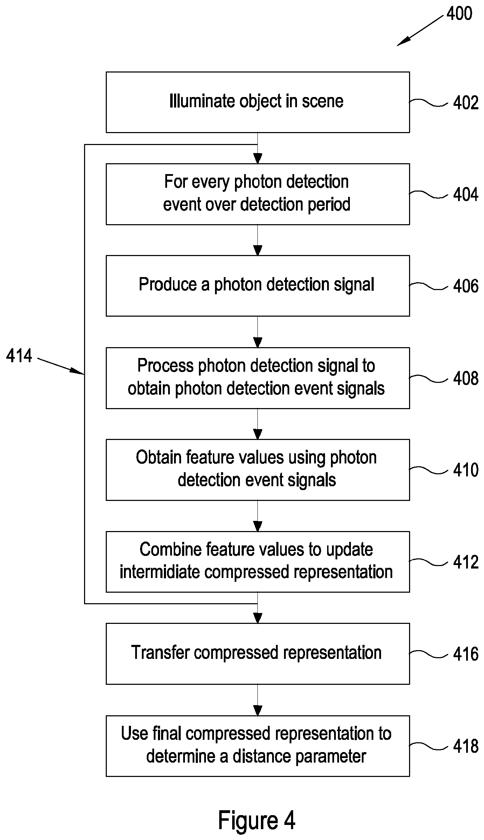

Figure 3 is a schematic diagram depicting a sketching method that can be implemented using, for example, the sensing device of Figure 2. Further details regarding the implementation of the method using the sensing device of Figure 2, are provided with reference to Figure 4.

At step 302, timing information is obtained. The timing information is representative of a distribution over time of photon detection events. For the purposes of discussion of the present method, the timing information comprises a plurality of photon detection times.

For each photon detection time, a plurality of feature values is obtained using the feature function (in this embodiment, a multi-variate feature function discussed above). In the present embodiment, as discussed above, the feature function is a multi-variate representation of a family of trigonometric functions having different frequencies, such that, for a single detection time, the multi-variate function outputs a plurality of feature values. The frequencies are pre-determined, as discussed in further detail with reference to Figure 2. In this embodiment, m frequencies are used, and for each frequency ($\omega_i$) an output value for the $\sin(\omega_i t_D)$ or $\cos(\omega_i t_D)$ for the range of m selected frequencies, $\omega_1, \ldots, \omega_m$.

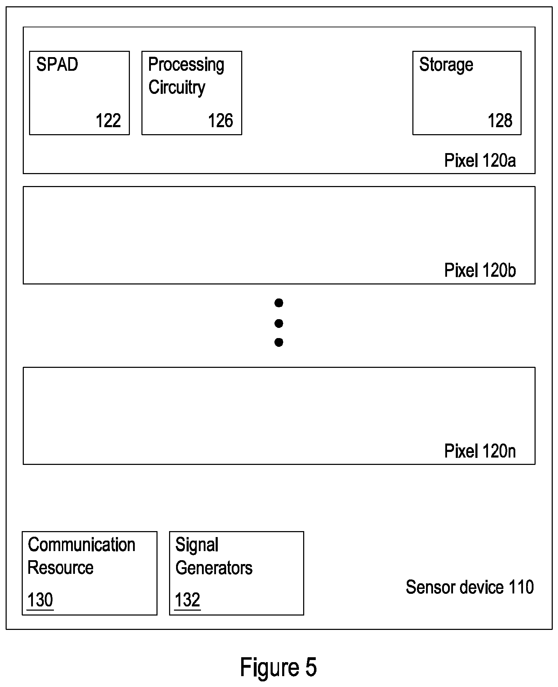

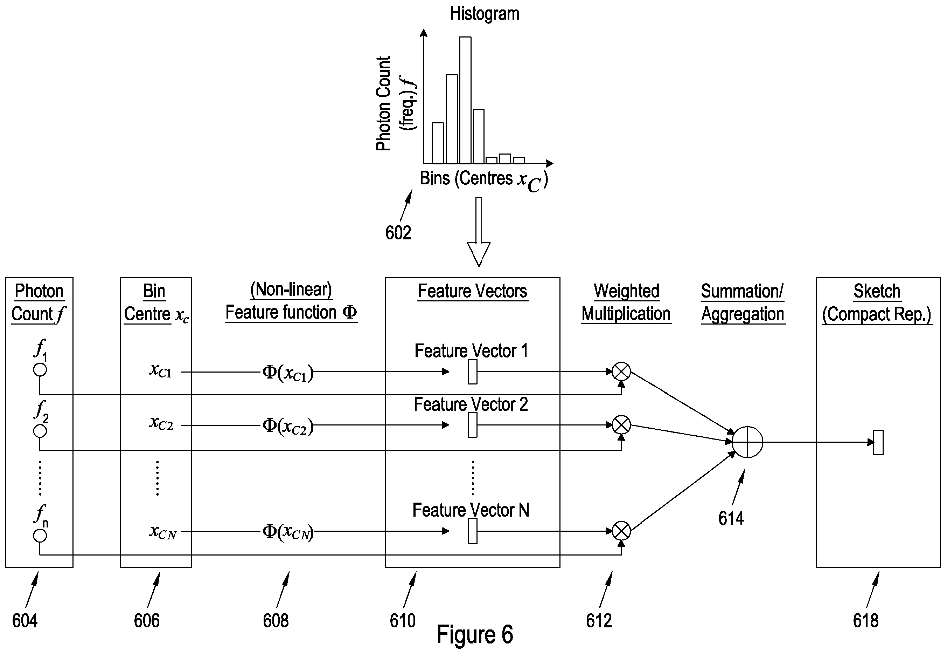

It will be understood that feature values can be determined using different feature functions, different timing information or different hardware configurations. Further examples are provided with reference to Figure 5 and 6.

At step 306, a feature vector is formed. The feature vector comprises the outputs of the feature function and is a representation of the feature values obtained using the feature function. The feature vector has a size dependent on the number of frequencies selected. In this embodiment, as m frequencies are selected, 2m feature values are obtained and therefore the feature vector is a $1 \times 2m$ dimensional array where each component is a real valued component.

At step 308, an intermediate instance of the compressed representation (also referred to as the intermediate compressed representation) is updated using the values of the feature vector determined at step 306. In the present embodiment, the feature vector values are combined with the intermediate compressed representation. In particular, the feature vector values are added to components of the intermediate compressed representation. In the present embodiment, the compressed representation is a $1 \times 2m$ dimensional array and the value of each component of the current sketch is updated by adding the corresponding component of the $1 \times 2m$ dimensional feature vector.

It will be understood that, for the first iteration, the intermediate compressed representation will be set to have zero value components such that the intermediate compressed representation of the method of Figure 3 is equal to the feature vector for the first photon detection time,

The method of Figure 3 is then repeated for each photon detection event, such that for each photon detection event, the compressed representation is updated, in real time, in response to a photon detection event. After n photon detection events, the final compressed representation can be used to estimate parameters of the distribution over time.

Figure 4 is a flow-chart illustrating, in overview, a method 400 performed by the imaging system comprising the sensor device 10, in accordance with embodiments.

For the purposes of the following description, the method is considered as occurring over a predefined detection period. The detection of photons is time gated such that photons are only detected during a predefined time window corresponding to the predefined detection period. The detection period can be varied by setting an operational parameter. At step 402, at the beginning of the detection period, the illumination source 12 illuminates the scene 14 to be imaged. As described with reference to Figure 1, one or more targets 16 are present in the scene 14.

In response to the illumination of the scene 14, photon detection events occur. In further detail, some light from illumination source 12 that is emitted into scene 14 is reflected by surfaces of targets and directed back to sensor device 10.

In addition, background or ambient light is also present throughout the environment and is incident on the sensor device 10. Therefore, the photons of the light incident on sensor device 10 can be considered as a combination of signal photons, reflected from targets 16, photons and a plurality of background photons. The time distribution is over the detection period. The time distribution is dependent on transmission and reflection properties of the surfaces of the targets 16 in the scene 14.

The photon detection events are distributed over time in accordance with an underlying time distribution. The underlying time distribution is in accordance with the target scene and the SPAD impulse response function. Knowledge of the underlying time distribution allows a distance between the sensor device 10 and the illuminated surfaces to be determined. The underlying distribution over time therefore has a relationship with the scene being imaged and may therefore be considered as an inherent distribution of the scene being imaged.

In the present embodiment, as described in the following, a process is performed by the sensor device 10, per-pixel. In the present embodiment, the process is performed per-pixel, for each photon detection event over the detection period, as represented at step 404.

At step 406, a photon detection signal is produced by the SPAD 22 for each photon detection event. The photon detection event is characterised by a detection time corresponding to the time the photon is detected by the SPAD 22.

At step 408, the TDC 24 associated with the SPAD 22 produces a photon detection event signal by processing the photon detection signal. The photon detection event signal comprises time data representative of the detection time. The time stamp data provides timing information for the sketching process.

At step 410, the time stamp data from each photon detection event signal is used as part of a sketching process performed by processing circuitry 26. In the present embodiment, the photon detection event signal including the time stamp data is provided to the processing circuitry 26. The processing circuitry 26 uses the detection time or a signal that is representative of the detection time to obtain the plurality of feature values for the photon detection event signal, substantially as described with reference to Figure 3. Therefore a plurality of feature values (2m, in the present embodiment) are determined at step 410. Step 410 can be considered as corresponding to steps 304 and 306 of Figure 3.

At step 412 the obtained feature values are combined as part of a combining process performed by processing circuitry 26. In the present embodiment, the obtained feature values are combined with an intermediate compressed representation to update the intermediate compressed representation, as described with reference to step 308 of Figure 3. In the present embodiment, the combination is a summation but may also include an averaging or any suitable form of aggregation. As part of step 412, the running totals represented by the updated intermediate compressed representation are stored on storage resource 28.

At step 414, the method returns to step 404 for the subsequent photon detection event in the detection period. In some embodiments, the method is performed until a pre-determined number of photon detection events occur. In such embodiments, a running total of the number of photon detection events processed is also stored until the pre-determined number of photon detection events is met. In some embodiments, the detection period has a pre-determine duration. These parameters can be selected by a user.

At step 416, a final compressed representation of the underlying distribution over time of the photon detection events, per pixel is provided. At this step, the generated compressed representation is transferred off the device using the communication resource 28.

Transmission of the compressed representation uses less transmission capacity than transmission of the plurality of photon detection event signals. The subsequent storage of the compressed representation uses less storage capacity than the storage of the plurality of photon detection event signals. In contrast to known methods, as only the compressed representation is transferred/stored in the above-described embodiment, as opposed to a full histogram, the transfer and/or storage of the compressed representation uses less communication and/or storage capacity that transfer and/or storage of the full histogram.

At step 418, the transferred compressed representation is used to obtain one or more parameters of the distribution over time. In particular, the compressed representation has sufficient information to allow an estimate of distance and intensity between sensor device 10 and targets to be determined. The techniques used to extract distance and intensity from the compressed representation are provided at the theoretical background section.

At step 416, the final compressed representation is transferred off the device to be processed using a parameter estimation process. It will be understood that, in other embodiments, the parameter estimation process can be performed by a processing resource of the sensing device such that only estimated parameters are stored or transferred (rather that the compressed representation).

In the above described embodiments, the raw measurements are not compressed in an invertible way. Rather, only the underlying statistical properties are captured. In some embodiments, properties of Fourier series (FS) measurements are exploited. FS averages have the special property that they explicitly remove any bias induced by background count, due to dark counts or background illumination. Essentially these measurements are blind to the background illumination and therefore may remove one of the biggest challenges in ToF imaging.

While in one embodiment, random FS averages are used, in other embodiments, the lowest frequency FS averages are used. In the simplest embodiment, a simple sine/cosine average pair of measurements (the first order Fourier Series component) are used to calculate a single reflection time of flight without background count bias. Multiple reflections per pixel (e.g. when imaging through glass) may be measured by taking a few FS averages: less than 20 may give sub bin accuracy.

In the above described embodiment, the pixel 20a is described as having processing circuitry for generating digital time stamp signals also referred to as photon detection event signals and this time stamp data is used to obtain a plurality of feature values. It will be understood that, in alternative embodiments, an alternative processing resource and/or hardware setup for obtaining feature values for a given photon detection event can be provided. A non-limiting example of an alternative setup is provided at Figure 5.

Performance of a sketching process using the device of Figure 5 allows for the step of first processing the photon detection event signal to obtain time data to be removed. Instead, the sensing device has signal generators for generating signals in real-time such that, in response to a photon detection event, the processing circuitry obtains feature values without the need to first generate time stamp data. Therefore, a feature value for a detection time can be obtained from the generated signals. In this example, a time to digital convertor for generating time stamp data is absent from device.

Figure 5 depicts a sensing device 110 that has a number of features that are as described with reference to Figure 2 and are not described here for brevity. In contrast to Figure 2, timing information of a photon detection event is used to obtain a feature value by sampling signals generated by signal generators 132. In this embodiment, the sensor 110 has signal generators 132 configured to generate oscillating signals (each signal corresponding to selected frequency). In the embodiment of Figure 5, the signal generators 132 generate a sine and cosine signal for each frequency (providing 2m signals altogether) i.e. a signal corresponding to $\sin(\omega_i t_D)$ or $\cos(\omega_i t_D)$ for the range of selected frequencies: $\omega_1, ..., \omega_m$. In response to a photon detection event detected by the SPAD 122, the processing circuitry 126 samples the generated signals to obtain feature values for that time, as part of a sample and hold process.

During the sample and hold process, the value of each sampled signal is digitised, for example, using an analogue to digital converter to give the feature values. In this way, the feature values are obtained. As described with reference to Figures 2, 3 and 4, the feature values are obtained in response to each photon detection event and the obtained feature values (obtained by sampling/digitizing the generated signals) are then used to update the intermediate compressed representation. After the predefined detection time, a final compressed representation is provided, as described with reference to Figure 4.

In the above described embodiments, a method of obtaining a compressed representation in which timing information, in the form of detection times for each photon detection event is used. In other embodiments, aggregated or averaged timing information can be used to determine the compressed representation.

Figure 6 depicts a sketching process for obtaining a compressed representation using a generated histogram. It will be understood that the sketching process can be performed using the sensing device of Figure 2 or Figure 5, adapted to perform and store a histogram. For example, the processing circuitry of such a device is configured to generate a histogram using the time stamp data and the sensing device has suitable storage capability to store the histogram. It will be further understood that known sensing devices that are configured to generate and store a histogram may be adapted to perform the sketching process of Figure 6.

For this method, the sensing device is configured to generate a high-resolution histogram 602 over an acquisition time. For example, a SPAD of the device generates photon detection signals that are converted into time stamp events by the TDC and a histogram generation method is performed using the time stamp data. Known histogram generation methods can be used.

Following the acquisition time, a sketching process is then performed on the histogram 602. In this method, the bin-center for each histogram bin is first determined at step 606, using known method. Each bin-center value is provided to the multi-variate feature function (608) to obtain a plurality of feature vectors (610), each feature vector corresponding to a histogram bin. The process of obtaining a feature vector from timing information (in this case, a bin center) is substantially as described with reference to Figure 3 (304/306) with the difference that an aggregated time is used as input in contrast to a detection time.

For each bin, a weighted multiplication is performed using the photon count (604) for the bin and the feature vector (610) to produce weighted feature vectors. The weighted feature vectors are then summed together to produce a compact representation for the weighted histogram. In contrast to the method of Figure 3, the compressed representation is not updated in real time during the acquisition period. The method of Figure 6 is instead performed following the acquisition period.

It will be understood that this method does not provide a reduction in storage on chip, as the histogram must be stored prior to performing the sketching process, however, this method will provide a reduction in data transfer off the device, as only the compressed representation is transferred.

Theoretical Background

The following comments are provided to describe the theoretical background of this work. In the following, solutions to the bottleneck of existing lidar techniques by calculating on-the-fly summary statistics of the photon time stamps, a so-called sketch, also referred to as a compressed representation, based on samples of the characteristic function of the ToF model, is explored. Distinct to compressive sensing, the goal is not to recover the photon counting data but rather the underlying probability distribution. In this sense, the probability model is directly estimated from a summary statistic and therefore the framework utilises much of the theory found in the generalised method of moments, empirical characteristic function and compressive learning literature. The size of the sketch scales with the degrees of freedom of the ToF model (i.e., number of objects in depth) and not with the number of photons or the fineness of the time resolution, without sacrificing precision in depth.

The sketch can be computed for each incoming photon in an online fashion, only requiring a minimal amount of additional computation which can be performed efficiently on-chip. The sketch can be shown to capture all the salient information of the histogram, including the ability to explicitly remove background light or dark count effects, in a compact and data efficient form, suitable for both on-chip processing or off-chip post processing. Furthermore, a compressive lidar image reconstruction algorithm is developed which has computational complexity dependent only on the size of the sketch. The described method paves the way for high accuracy 3D imaging at fast frame rates with low power consumption. In summary, the main contributions of this work may be: a principled approach for compressing time-of-flight information in an online fashion without the requirement to form a histogram and without compromising depth resolution; a compressive single-photon lidar algorithm is proposed which does not scale with either the number of photons or the time stamp resolution in terms of space and time complexity; statistical efficiency, given a compression rate (or sketch size), is quantified for different single-photon lidar scenarios, showing that only limited measurements of the characteristic function are needed to achieve negligible information loss.

A. Lidar Observation Model

The photon count at time stamp $t \in [0, T - 1]$ for an arbitrary pixel can be modelled as a Poisson distribution

$$y_{t_k} | (r, b, t_k) \sim \mathcal{P}(rh(t - t_k) + b), \qquad (1)$$

where $r \geq 0$ denotes the reflectivity of the detected surface, $h(\cdot)$ is the impulse response of the system and $b$ defines the level of background photons. The number of discretized time stamp bins over the range of interest is denoted by $T$. The time stamp $t$ is discretized over the range $[0, T - 1]$ dependent on the time-stamp resolution $\Delta t$. For simplicity, here it is assumed that the integral of the impulse response $H = \sum_{t=1}^{T} h(t)$ is constant although the proposed approach can accommodate more complex scenarios. If the lidar system is in free running mode where multiple acquisitions of a surface/object are obtained, then the interval $[0, T - 1]$ can be thought of as circular in the sense that time-stamp $T$ is equivalent to the time-stamp 0.

Alternatively, one can instead model the time of arrival of the $p^{th}$ photon detected. It is assumed that there are $K$ distinct reflecting surfaces, where $\alpha_k$ and $\alpha_0$ denote the probability that the detected photon originated from the $k^{th}$ surface and background sources, respectively. Let $x_p \in [0, T - 1]$ denote the time stamp of the $p^{th}$ photon where $1 \leq p \leq n$, then $x_p$ can be described by a mixture distribution:

$$\pi(x_p | \alpha_0, ..., \alpha_K, t_1, ..., t_K) = \sum_{k=1}^{K} \alpha_k \pi_s(x_p | t_k) + \alpha_0 \pi_b(x_p) \qquad (2)$$

where $\sum_{k=0}^{K} \alpha_k = 1$. The distribution of the photons originating from the signal and background are defined by $\pi_s(x_p|t) = h(x_p - t)/H$ and the uniform distribution $\pi_b(x_p|t) = 1/T$ over $[0, T - 1]$, respectively. Often in practice, the signal distribution $\pi_s$ is modelled either using a discretized Gaussian distribution over the interval $[0, T - 1]$ or through the data driven impulse function which is calculated through experiments.

B. Summary Statistics

The acquisition goal is to obtain parameter estimates of the signal model in Eqn (2), given the time-stamp of photons detected. Parameter estimation usually involves the inference of a set of parameters $\theta \in \Theta \subset \mathbb{R}^{2k+1}$

associated to a probability model $\pi( \cdot | \theta)$ defined on some space $x \in \mathbb{R}^d$. In the case of single-photon lidar, the dimension $d = 1$. Typically, a finite dataset $\mathcal{X} = \{x_i\}_{i=1}^n$ of $n$ samples is observed, which is assumed is sampled from the distribution given in Eqn. 2. Maximum likelihood estimation (MLE) is a traditional parameter estimation method whereby a likelihood function associated with the finite data is maximized with respect to the model parameters, e.g.

$$\hat{\theta} = \arg\min_{\theta} \frac{1}{n} \sum_{i=1}^n \log \pi(\mathbf{x}_i \mid \theta). \qquad (3)$$

1) *Generalised Method of Moments:* In some cases, the likelihood function might not have a closed form solution nor a computationally tractable approximation. Generalised method of moments (GeMM) is an alternative parameter estimation method where one estimates θ by matching a collection of generalised moments with an empirical counterpart computed over a set of finite data sampled from the distribution $\pi(x \mid \theta)$. Given a nonlinear function $g : \mathbb{R}^d \to \mathbb{C}^m$, then the expectation constraint is defined as

$$\mathbb{E}_{\theta} g(\mathbf{x}; \theta_0) = 0, \qquad (4)$$

where $\mathbb{E}_{\theta}$ denotes the expectation with respect to the probability distribution $\pi(x \mid \theta)$. Typically, the GeMM estimator is obtained by minimising a quadratic cost of the empirical discrepancy with respect to θ to try impose the moment constraints of (4). Let us define

$$g_n(\mathcal{X}; \theta) := \frac{1}{n} \sum_{i=1}^n g(\mathbf{x}_i; \theta), \qquad (5)$$

calculated over $\mathcal{X} = \{x_i\}_{i=1}^n$, then a GeMM classically takes the form:

$$\hat{\theta} := \arg\min_{\theta} g_n(\mathcal{X}; \theta)^T \mathbf{W} g_n(\mathcal{X}; \theta), \qquad (6)$$

where **W** is a symmetric positive definite weighting matrix that may depend on θ.

2) *Compressive Learning:* Building on the concept of GeMM compressive learning utilises generalised moments of the data but with the distinct goal of reducing signal acquisition, space and time complexities. The link to GeMM is established by separating the function g into the following particular form:

$$g(\mathbf{x}; \theta) = \Phi(\mathbf{x}) - \mathbb{E}_{\theta} \Phi(\mathbf{x}), \qquad (7)$$

where $\Phi : \mathbb{R}^d \to \mathbb{C}^m$ is often referred to as the multi-variate feature function.

The separable form decouples the measured moments, $\Phi(x)$, from the parameters θ that are to be estimated. This is not a usual assumption in GeMM, although it may arise in particular cases. By denoting the empirical mean or the so-called sketch as

$$\mathbf{z}_n := \frac{1}{n} \sum_{i=1}^n \Phi(\mathbf{x}_i), \qquad (8)$$

$\theta$ can be estimated solely from the sketch $\mathbf{z}_n$, by minimising

$$\hat{\theta} = \arg\min_{\theta} \|\mathbf{z}_n - \mathbb{E}_\theta \Phi(\mathbf{x})\|^2_{\mathbf{W}}, \qquad (9)$$

which is the particular compressive GeMM loss of Eqn (6). Elsewhere, the weighting matrix W for compressive single-photon lidar is defined.

The separable form of g in Eqn (7) allows a sketch statistic $\mathbf{z}_n$ to be formed with a single pass of the data without the need to store the full dataset $\mathcal{X} = \{\mathbf{x}_i\}_{i=1}^n$ and it can easily be updated on the fly with minimal computational cost. The sketch statistic has size $m$, or size $2m$ if decoupled into its real and imaginary components, which, fundamentally, scales independent of the dimensions of the dataset $X$ which in the case of single-photon lidar is the photon count n or the binning resolution T.

3) Empirical Characteristic Function: A specific type of GeMM is the empirical characteristic function (ECF) estimation, and occurs when the generalized moment is chosen to be $\Phi(x) = \left[ e^{-i\omega_j^T x} \right]_{j=1}^m$, where $i = \sqrt{-1}$ and $\omega_j$ is a discrete set of frequencies. It is of particular interest as the expectation of $\Phi$, namely $\Psi_\pi(\omega) = \mathbb{E}_\theta e^{-i\omega_j^T x}$, is specifically the characteristic function (CF) of the probability distribution $\pi(\mathbf{x}|\theta)$ at frequency $\omega_j$. The CF exists for all distributions, and often has a closed form expression. Moreover, it captures all the information of the probability distribution, therefore giving a one-to-one correspondence between the CF and the probability distribution $\pi(\mathbf{x}|\theta)$. The CF also has the favourable property that it decays in frequency, i.e. $\Psi_\pi(\omega) \to 0$ as $\omega \to \infty$, under mild conditions on the probability distribution $\pi(\mathbf{x}|\theta)$].

For a single depth observation model in Eqn (2) (i.e. $K = 1$) and an impulse response function h, the characteristic function of the observation model is defined by

$$\Psi_\pi(\omega) = \alpha_1 \Psi_{\pi_s}(\omega) + \alpha_0 \Psi_{\pi_b}(\omega)$$
$$= \alpha_1 \hat{h}(\omega) e^{i\omega t} + \alpha_0 \operatorname{sinc}(\omega T/2) \qquad (10)$$

where $\operatorname{sinc}(x) = \sin(x)/x$ and $\hat{h}$ denotes the (discrete) Fourier transform of the impulse response function h. It should be noted that different distributions $\pi_b$, and hence CFs, to model the detected photons originating from more complex background sources, although this is beyond the scope of this paper.

The feature function $\Phi(x)$ is a complex valued function of size $m$. With regards to hardware implementation, it is often preferable and convenient to work directly with real valued functions. The complex term $e^{i\omega x}$ can be alternatively written as $\cos(\omega x) + i \sin(\omega x)$, where $e^{i\omega x}$ has been decoupled into its real and imaginary components. As a result, the feature function $\Phi$ can be equivalently written as a real valued feature function $\Phi: \mathbb{R}^d \mapsto \mathbb{R}^{2m}$, consisting of $2m$ real valued terms by stacking the real and complex components, for e.g.

$$\Phi(x) = \begin{bmatrix} \cos(\omega_1 x) \\ \vdots \\ \cos(\omega_m x) \\ \sin(\omega_1 x) \\ \vdots \\ \sin(\omega_m x) \end{bmatrix}.$$

For sake of fair comparison to existing hardware implemented methods in the literature, the results and figures presented represent a sketch of size $2m$, consisting of $2m$ real valued measurements. The nature of the feature function, in terms of it being represented by a complex or real valued function, will be made clear in its context throughout the text.

C. Sketched Lidar

The potential of using a sketch for single-photon lidar and to motivate the design of the sketch sampling procedure, which will be discussed in the following section.

*Compressing Single Depth Data*

In the absence of photons originating from background sources (i.e. SBR = ∞) and the presence of a single surface or object, the sample mean of all the photon time-stamps ($\Phi(x) = x$) is the simplest summary statistic for estimating the single location parameter $t_1$. This only holds in the noiseless case as the sample mean estimate is heavily biased toward the centre of the histogram when background photons are detected.

Suppose, instead the cosine and sine of each photon count (x) is observed with angular frequency $\omega = 2\pi/T$, namely the feature function at this frequency is:

$$\Phi(x) = \begin{bmatrix} \cos(\frac{2\pi}{T}x) \\ \sin(\frac{2\pi}{T}x) \end{bmatrix}, \qquad (11)$$

and denote $z_n$ the real valued sketch of size 2 computed over the dataset $X$ as in Eqn 8. It is possible to recover an estimate of the single depth location parameter $t_1$ directly from the sketch, via the trigonometric mean

$$\hat{t}_1 = \frac{T}{2\pi} \arg\left\{ \sum_{j=1}^{n} \cos\left(\frac{2\pi x_j}{T}\right) + i \sum_{j=1}^{n} \sin\left(\frac{2\pi x_j}{T}\right) \right\} \qquad (12)$$

where arg denotes the complex argument . As the background photons are distributed uniformly over the interval $[0, T-1]$ ($\pi_b(x) = \frac{1}{T}$), the expected moment of the photons originating from background sources is zero, $\mathbb{E}_{x \sim \pi_b} \Phi(x) = 0$. The resulting estimate of the single depth parameter $t_1$ is therefore an unbiased estimator of the location parameter $t_1$. The estimator in Eqn 12 coincides with a circular mean estimator.

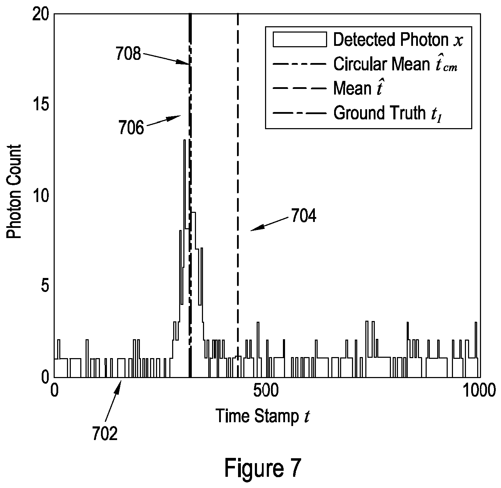

A simulated example is provided. A pixel of T = 1000 histogram bins with a signal-to-background ratio (SBR) of 1 and a total of n = 600 photons is simulated, where the time stamp of each photon is denoted by $X = \{x_i\}_{i=1}^{n}$. The data was simulated using a Gaussian impulse response function with σ = 15 and a true position at time stamp $t_1$ = 320. Computing the sketch $z_n$ from Eqn 8 and using Eqn. 12 the sketch estimate $\hat{t}_{cm}$ = 323.3 is obtained and the sample mean estimate of $\hat{t}$ = 434.1 is obtained. The TCSPC histogram along with both the circular and standard mean estimates as well as the location parameter $t_1$ are shown in Figure 7 where it is evident that the circular mean estimate does not suffer from the noise bias inherent in the sample mean. Figure 7 depicts the underlying distribution of detected photons 702, the mean 704 (also denoted by $\hat{t}$ and the determined circular mean 706 (also referred to as $\hat{t}_{cm}$). Also depicted is ground truth ($t_1$).

Importantly, the sketch formed using the moment in Eqn 11 is equivalent to the ECF sketch $z_n = \frac{1}{n}\sum_{j=1}^{n} e^{i\omega x_j}$ sampled at $\omega = \frac{2\pi}{T}$ decoupled into both its real and complex parts. In fact, the estimate $\hat{t}_1$ in Eqn 12 is the optimal estimator to the compressive ECF sketch detailed in Eqn 9. Principally, for this example, only 2 values need to be stored/transferred to estimate accurately the depth location of the object or surface, without the requirement to resort to the original photon time-stamped data.

For the remainder of this section, this example approach of forming a sketch is generalized to arbitrary size and sampling the ECF at multiple frequencies. This enables statistically efficient estimates for the single surface case to be obtained and to solve more complex lidar scenes including several surfaces with varying intensities where more salient information of the observation model is required.

*Sampling the ECF*

Recall that the observation model $\pi$ in Eqn 2 is discretized over the interval [0, T - 1] which therefore can be considered to be a sufficient sampling if the distribution in Eqn 2 is approximately bandlimited. As a result, the characteristic function $\Psi\pi(\omega)$ has a finite basis characterized by the set of frequencies

$$\left\{ \frac{2\pi j}{T} \;\middle|\; j \in [0, T-1] \right\}. \qquad (13)$$

The approach described above can be generalized by sampling multiple frequencies from the finite basis in order to construct the ECF sketch. As is the case for the circular mean, the frequencies $\omega = 2\pi j/T$ for $j \in [0, T-1]$ correspond to the zeros in the sinc function associated with the background pdf $\pi_b$ seen in Eqn (10). Therefore a sketch of arbitrary dimension that is also blind to photons originating from background sources can be constructed by avoiding the zero frequency $\omega = 0$ of the finite basis. As a result, the set of orthogonal frequencies are defined by

$$\Omega := \left\{ \omega_j = \frac{2\pi j}{T} \;\middle|\; j \in [0, T-1] \right\}. \qquad (14)$$

This set is referred to as the orthogonal frequencies as it defines regions over the interval of the observation model's characteristic function

*Sampling Schemes*: In order to construct a sketch, sufficient salient information of the characteristic function $\Psi_\pi$ should be retained such that identification and estimation of the unique location and intensity parameters $\theta$ of the observation model $\pi(x \mid \theta)$ defined in Eqn 2 is possible. It was discussed previously that the CF of a probability distribution decays in frequency. Furthermore, as the observation model is discretized over the interval, it is assumed that the characteristic function of the observation model is approximately band-limited. A natural sampling scheme would therefore be to sample the ECF at the first $m$ frequencies of the orthogonal frequencies $\Omega$ to capture the maximum energy of the CF. In other words, the CF of the observation model can be truncated whilst avoiding the zero frequency.

Alternatively, provable guarantees for estimating mixture of Gaussian models may be provided, under certain conditions based on random sampling (cf. compressive sensing) of the CF. It is understood that the higher frequencies of the CF may provide further information to help discriminate distributions that are close in probability space. Moreover, if the CF decays slowly in frequency then the energy of the CF will be spread more throughout the set of orthogonal frequencies. Therefore an alternative sampling scheme is provided in which the set of orthogonal frequencies are randomly sampled with respect to some sampling law $\Lambda$. Orthogonal frequencies are sampled by:

$$(\omega_1, \omega_2, \ldots, \omega_m) \sim \Lambda_{\hat{h}} \qquad (15)$$

where $\Lambda_{\hat{h}}$ denotes the cumulant distribution function of $\hat{h}$. To formalize, the following sampling schemes are described in order to construct the sketches:

1) Truncated Orthogonal Sampling: Sample the ECF at the first m frequencies i.e. j = 1,2, ... , m from $\Omega$.

2) Random Orthogonal Sampling: Sample the ECF at the set of frequencies randomly governed by the distributing law $\Lambda_{\hat{h}}$.

Depending on the circumstances of the lidar device one or the other sampling scheme may perform better. It has been found that this is the case with both synthetic and real datasets.

*Statistical Estimation*

Once the ECF sketch is constructed using either sampling scheme, the parameters $\theta$ of the observation model $\pi$ $(x \mid \theta)$ are estimated from the obtained sketched (compressed representation), denoted $\mathbf{z_n}$. In general, there is no closed form expression to estimate $\theta$ from the sketch of arbitrary size as is the case for the circular mean estimate in Eqn 12. It is well documented in the ECF and GeMM literature that a complex valued ECF sketch $\mathbf{z}_n$ of size m (or size 2m if decoupled into its real and complex components), computed over a finite dataset $X$ satisfies the central limit theorem. Formally, a complex valued sketch $\mathbf{z}_n \in \mathbb{C}^m$ converges asymptotically to a Gaussian random variable.

$$\mathbf{z}_n \overset{\text{dist}}{\longrightarrow} \mathcal{N}\left(\Psi_\pi, n^{-1}\Sigma_\theta\right), \qquad (16)$$

where $\Sigma_\theta \in \mathbb{C}^{m \times m}$ has entries $(\Sigma_\theta)_{ij} = \Psi_\pi(\omega_i + \omega_j) - \Psi_\pi(\omega_i)\Psi_i(\omega_j)$ for i,j=1,2... ,m.

The asymptotic normality result in Eqn 16 naturally leads to a sketch maximum likelihood estimation (SMLE) algorithm that consists of minimising the following:

$$\arg \min_\theta \ \frac{m}{2} \log \det(\Sigma_\theta) + n(\mathbf{z}_n - \mathbf{z}_\theta)^T \Sigma_\theta^{-1}(\mathbf{z}_n - \mathbf{z}_\theta), \quad (17)$$

where for convenience $\mathbf{z}_\theta = \left[\Psi_\pi(\omega_j)\right]_{j=1}^m$. For an observation model consisting of K surfaces and a general impulse response function h, recall that

$$\mathbf{z}_\theta = \left[\sum_{k=1}^K \alpha_k \, \hat{h}\left(\omega_j\right) e^{i\omega_j t_k}\right]_{j=1}^m \qquad (18)$$

and $\theta = (\alpha_1, ..., \alpha_K, t_1, ..., t_K)$. Note that the sinc function is dropped on the assumption that one of the proposed sampling schemes is being used. Minimising Eqn 17 is equivalent to minimising the compressive GeMM objective function defined in Eqn 9 with the weighting function chosen to be $W = \Sigma_\theta^{-1}$. The weighting matrix W is asymptotically optimal in the sense that it minimises the variance of the estimator $\hat{\theta}$ from the sketch.

In practice $\Sigma_\theta$ is $\theta$ dependent as it is a function of the underlying parameters $\theta$ that are to be estimated. There are various well established methods in the GeMM and ECF literature that tackle the difficulty of approximating $\Sigma_\theta$ and estimating $\theta$ simultaneously. For example, the K-L method may be used which iteratively estimates $\Sigma_\theta$ and $\theta$ in a two stage procedure by fixing and updating one at a time. Some known methods fix $\Sigma_\theta$ after only a few iterations of the K-L approach to reduce the computational complexity of the algorithm, although this typically comes at the cost of introducing sample bias. Occasionally, the covariance matrix is set throughout to be the identity, $\Sigma_\theta = 1$, reducing Eqn 17 to a standard least squares optimization but this generally results in a less statistically efficient estimator.

In this work, the method of estimating $\Sigma_\theta$ and $\theta$ simultaneously at each iteration is adopted. This approach is commonly referred to as Continuous Updating Estimator (CUE) and obtains estimates that do not produce sample bias like the two-step K-L approach and can often lead to more statistically efficient estimators. However, the SMLE method is not restricted to the CUE and in certain situations practitioners may choose to sacrifice unbiased and efficiently optimal estimators for a reduced computational complexity by considering the other methods discussed.

The optimisation problem in Eqn 17 is also typically non-convex and can suffer from spurious local minima. For the case when there is only a single surface, the SMLE algorithm is initialised using the analytic circular mean solution in Eqn 12 with minimal added computational overhead. From our experience with synthetic and real data, the circular mean estimate generally initialises the SMLE algorithm within the basin of the global minima, hence the issues associated with non-convex optimization are circumvented. For the case of multiple surfaces, a coarse uniform grid is formed across $[0, T-1]^K$ and initialised at the smallest SMLE loss.

*Central Limit Theorem*

One of the main advantages of the SMLE lidar approach from Eqn. 16 is that even at low photon levels (i.e. small n), the SMLE estimates quickly follow the central limit theorem (CLT) and provide a good approximation of its expectation. In contrast, known TCSPC histogram methods may be a poor approximation to its expectation as each time stamp bin t has only a small number of photons. Thus efficient processing of the full histogram data requires careful consideration of the underlying Poisson statistics. It was found that the estimate of the time parameter satisfies the central limit theorem with respect to photon count n, and that the sketched lidar CLT results of Eqn. 16 hold even for low photons levels, therefore the SMLE loss of Eqn. 17 is a well-justified loss to minimize.

*Statistical Efficiency*

It was found during the course of this work, that only a moderate real valued sketch of size 2m is needed to achieve negligible loss of information. The results are based on the asymptotic normality property discussed in Eqn 16, and, it was found that in practice this normality result holds even for small photon counts of n = 10.

Experimental Results

The following comments regarding experimental results are also provided. The compressive lidar framework described was evaluated on synthetic and real data with increasingly complex scenes. The method is compared with classical algorithms working on the full data space (i.e. no compression) namely log-matched filtering and expectation maximization (EM). Moreover, the results are also compared to the alternative compression technique of a known coarse binning. Both the log-matched filtering and EM algorithms estimate the location parameters using the full data and therefore the results obtained from these methods set a benchmark to the estimation accuracy when no compression takes place. The real valued sketch consisting of 2m real value measurements is used in the following results for the sake of fair comparison.

1) Processing: Restoration of depth imaging of single-photon lidar consists of estimating a 3D point cloud from a lidar data cube containing the number of photons $n_{i,j,t}$ in pixel (i, j) at time stamp t, where $i \in [1,...,Nr]$, $j \in [1,...,Nc]$ and $t \in [0, T - 1]$. The average photon count for the whole data cube is denoted by

$$\bar{n} = \frac{1}{N_r N_c T} \sum_{t=0}^{T-1} \sum_{i=1}^{N_r} \sum_{j=1}^{N_c} n_{i,j,t}$$

Each pixel (i, j) of the data cube is processed to estimate the true location and intensity parameter, denoted $t_1$ and $\alpha$, respectively. A data driven impulse response is given for each dataset and the characteristic function of the impulse response function can be obtained by using Eqn. 10.

2) Evaluation Metrics: Two different error metrics are used to evaluate the performance of our proposed sketched lidar framework. The root mean squared error (RMSE) between the reconstructed image and the ground truth is considered. Given that $t_{i,j,k}$ is the location of the kth peak in pixel (i, j) and $\hat{t}_{i,j,k}$ is the estimated counterpart, then the root mean squared error of the reconstructed image is

$$\mathrm{RMSE} := \sqrt{\frac{1}{K N_r N_c} \sum_{i=1}^{N_r} \sum_{j=1}^{N_c} \left( \sum_{k=1}^{K} t_{i,j,k} - \hat{t}_{i,j,k} \right)^2}. \quad (26)$$

Secondly, the percentage of true detections $F_{true}(\tau)$ is compared with a resolution $\tau$. That is, a true detection occurs if $|t_{i,j,k} - \hat{t}_{i,j,k}| \leq \tau$. When plotted as a function of $\tau$, this metric quantifies the variability of the estimate.

The compression of both the sketched lidar and coarse binning approach is measured in terms of the dimension reduction achieved by the statistic with respect to the raw TCSPC data and is quantified by the metric $\max\{\frac{2m}{T}, \frac{2m}{n}\}$, which is dependent on the dimensions, T and n, of the lidar scene. As previously discussed in the Theoretical Background section, we use the real-valued sketch of size 2*m* for sake of fair comparison with the technique of coarse binning.

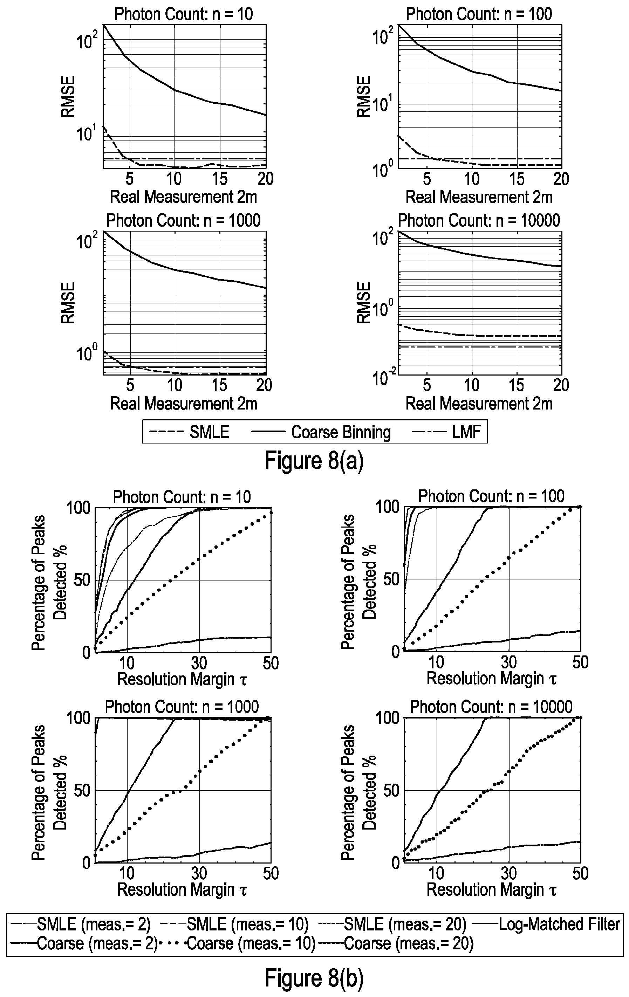

Figure 8(a) depicts the RMSE as a function of the number of real measurements (2m) for both the sketched lidar technique (lower line) and the coarse binning method (upper line). The log match filter (the dashed lined) is shown for comparison. Figure 8(b) depicts the percentage of peak detected as a function of the time stamp resolution for both the sketched lidar method (upper line) and the coarse binning method for varying measurement size.

The sketched lidar framework was also evaluated on two real datasets of increasing complexity. Firstly, a polystyrene head was imaged which consists mostly of a single peak and secondly, a scene where two humans are standing behind a camouflaged net, which contains 2 objects per pixel with varying intensity.

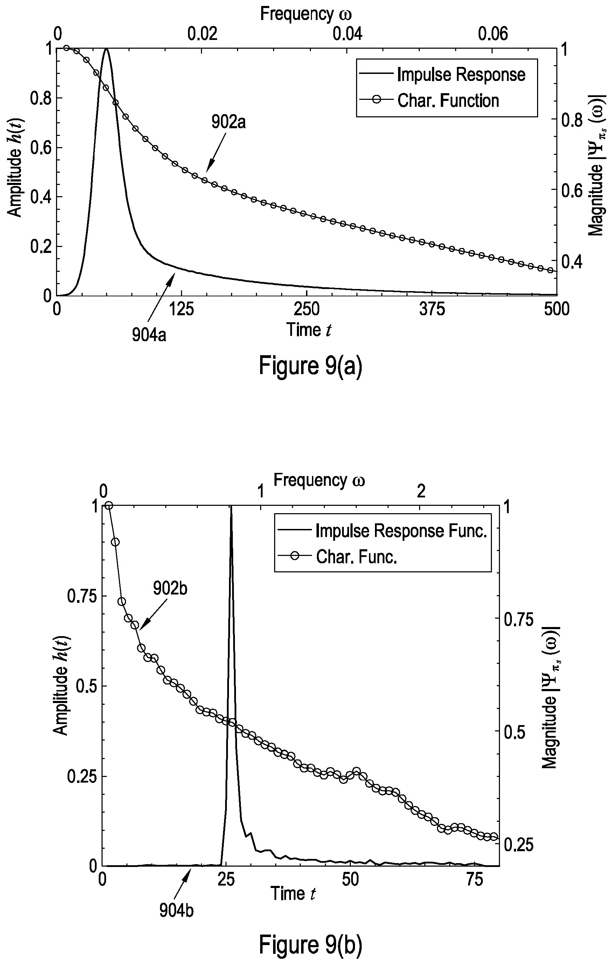

Figures 9(a) depicts the characteristic function (upper line 902a) of the data driven response function (lower line 904a) for the first data set (the polystyrene head data set). Figure 9(b) depicts the characteristic function (upper line 902b) of the data driven response function (lower line 904b) for the second data set (the camouflage data set).

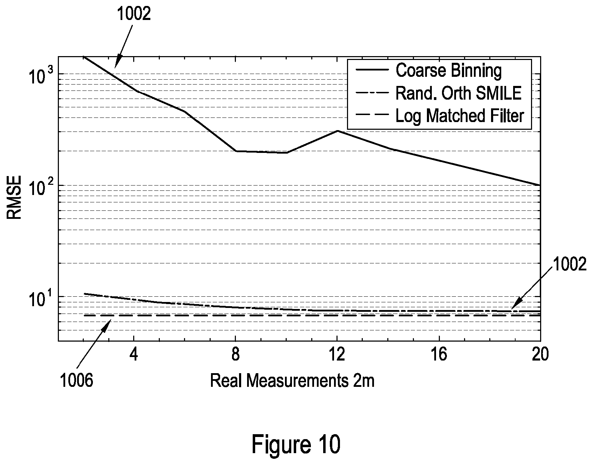

Figure 10 depicts the RMSE as a function of the number of real measurements (2m). The random orthogonal sketched lidar (lower line 1002) and the coarse binning method (upper line 1004) are compared with the full data estimated via log matched filtering (dashed line 1006).

Figure 11(a) and Figure 11(b) depict lidar reconstructions of the sketched lidar and coarse binning method for real measurement size 2,8,20 for the first dataset (face data set) and the second data set (camouflage data set), respectively. Both the log matched filter reconstruction and the ground truth image are provided for comparison.

In above described embodiments, a model of the distribution over time based on an impulse response function or an empirical approximation of the impulse response function. In some embodiments, the impulse response function used is dependent on intensity of the signal received (for example, the intensity of the reflected light). In such embodiments, the shape or size of the impulse response function is dependent on the intensity. The most suited impulse response function may have a different functional form for different targets and scenes. As a first non-limiting example, light received from an example target may be modelled best by a sharply peaked function, for example, a delta function or a functional approximation. As a second non-limiting example, the target may reflect light at a lower intensity, such that light received from the target may be modelled by a wider peak. It has been found that using an intensity dependent model of the distribution over time, problems associated with Range-Walk (for example, including intensity dependent pile-up effects due to the SPAD detector dead time) may be addressed.

In the above described embodiments, a number of different functional forms for feature functions are described that have one or more properties such that the combination of feature values generated by the feature functions preserves signal information and/or supresses background information and/or distinguishes signal information from background information in the compressed representation. Examples provided above include functions that have properties such as periodicity and are non-linear (for example, periodic pairs of cosine and sine functions over a number of different frequencies). As described above, properties such as these allow compressed representations (sketches) to retain sufficient information to allow reconstruction of the time distribution off the device. Such feature functions may include sinusoidal feature functions.

In such embodiments, as described above, feature functions are used to generate feature values on the processing resource of the device (for example, by sampling a generated signal or using a suitable algorithm). As such, a low complexity approximation of the feature functions may be desirable, such as a CORDIC approximation, as described above.

In further embodiments, it has been found that approximating sinusoidal feature functions using local polynomial approximating functions (referred to in the following as spline functions) may offer additional advantages. The spline functions may be considered to form a basis set across a time period and may also be referred to as basis functions It has further been found that the set of spline functions have suitable properties that allow a compressed representation (sketch) to be formed either with or without the step of approximating the sinusoidal features.

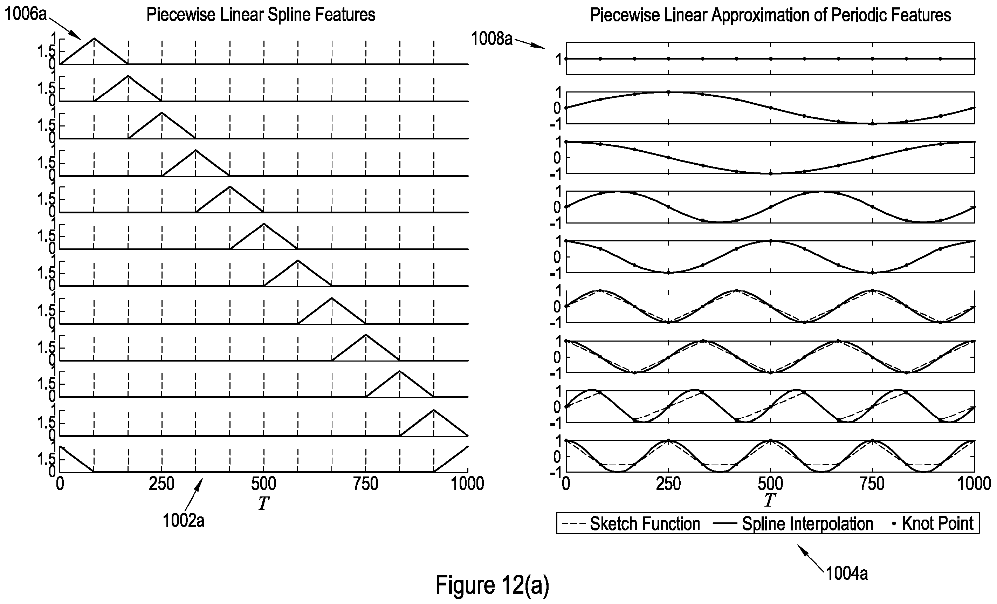

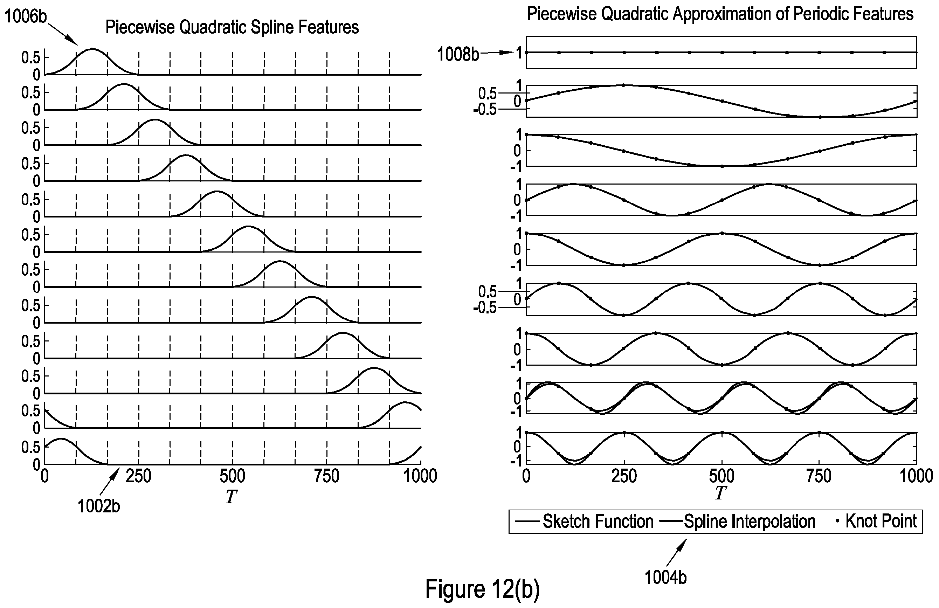

In such embodiments, a set of N spline functions are used to form the compressed representation. The spline functions may also be referred to as spline feature functions and are piecewise polynomial functions. Each spline function has a local, functional portion (a polynomial portion) centred about a respective time. This portion is referred to a local portion in the following but may also be referred to a functional portion or a polynomial portion. In some embodiments, for example, those depicted in Figure 12, the respective times of the set of spline functions are regular over the time period T and divide the period is divided into N equal time intervals. Sets of suitable spline functions with N equal to 12 are depicted in Figure 12(a) and (b). It will be understood that, while in some embodiments, the time periods are equal and the spline functions are regular over the time period, in other embodiments, the basis functions may have an irregular distribution. The left hand side of Figure 12(a) depicts a set of spline functions that may also be referred to as linear basis functions 1002a and the left hand side of Figure 12(b) depicts a set of spline function that may also be referred to as quadratic basis functions 1002b.

In Figure 12(a), as an example, a local portion of a first basis function is labelled 1006a and is centred at a first time of the period T. The local portion 1006a is triangular with a linear increasing portion and a linear decreasing slope. It will understood that the local portion overlaps in time with the local portion of either the local portion of the preceding basis function or the local portion of the subsequent basis function in the set of basis functions. In Figure 12(b), as an example, a local portion of a first basis function is labelled 1006b and is centred at a first time of the period T. The local portion is quadratic with a quadratically increasing portion and a quadratically decreasing portion. It will understood that the local portion overlaps in time with the local portion of at least one other basis function. In Figure 12(a), the local portion overlaps in time with one other basis function and in Figure 12(b) the local portion overlaps in time with the local portions of two other basis functions.

In Figure 12(a) the local portion is triangular made up of a first linear upward slope and a second linear downward slope. In Figure 12(b) the local portion is quadratic. It will be understood that other low order polynomials may be. For example, in some embodiments, polynomials having order lower than or equal to 3 may be suitable. In addition, in some embodiments, polynomials having order greater than or equal to 1 may be suitable. The remainder of each spline function has a zero or constant value. Each spline function is periodic such that the local portion repeats once every time period T.

The spline functions can be used to approximate sinusoidal or other periodic, non-linear functions that corresponding to the feature functions of to the embodiments described above. The spline functions can be interpolated to form piecewise polynomial functions.

Figures 12(a) and 12(b) depict how a non-linear, periodic function can be approximated using a spline interpolation process. The sets of functions of Figure 12(a) and 12(b) have the properties of being periodic and can be combined to form interpolations of the sinusoidal functions at different frequencies (see right hand side of Figure 12(a) and (b)). As shown in Figure 12, the set of spline functions span the time period T in that the local polynomial portion of each of the spline functions overlaps in time with the local portion of the preceding and succeeding spline functions in the set. It will be understood that, in these embodiments, the time period is divided into N equal time portions, and there are N spline functions, however, in other embodiment, the time period may be divided into N unequal time portions. At least two of the spline functions are non-zero over each time portion. It will be understood that the spline functions overlap such that at least two spline functions return a non-zero output for a photon detection event (for example, for Figure 12(a), two functions return a non-zero value and for Figure 12(b), three functions return a non-zero value).

As can be seen from Figure 12(a) and (b), the set of spline functions can be linearly combined to form piecewise approximations, in this case, of sinusoidal functions. As the local polynomial approximations of the feature functions are calculated on a fixed grid over time, then the same polynomial components can be generated for all feature functions (over a number of frequencies) using linear combinations of the spline functions.

The right hand side of Figure 12(a) depict the set of sinusoidal feature functions 1004a (in this case piecewise polynomial approximations of sinusoidal functions) that are formed using the set of spline functions 1002a on the left hand side of Figure 12(a). It will be understood that a number of different frequencies of the sinusoidal feature functions may be generated using the same set of spline functions. Similar comments apply for Figure 12(b), in which the right hand side of Figure 12(b) depict the set of interpolated functions 1004b that can be generated using the set of functions 1002b on the left hand side of Figure 12(b).

It will be understood that, as was described with reference to other embodiments, the T of Figure 12, also referred to as the period T, corresponds to the introduced time window over which photon detection occurs (in lidar this is referred to as *time gating*). The time window may also be referred to as the acquisition time or detection time.

The spline functions and their output can be used to form the compressed representation either by approximating non-linear, periodic functions or directly. In some embodiments the parameter estimation process may apply suitable algorithms directly to the compressed representation formed by the output of the spline functions, rather than approximating the sinusoidal functions. In such embodiments, the spline feature functions are used to from a distinct sketch independent of their ability to approximate sinusoidal functions. It will be understood that the spline set of functions may capture substantially the same distribution information as the sinusoidal functions.

Using the spline functions to form a compressed representation may offer advantages. For example, each spline function has a polynomial portion localized in time (i.e. non-zero over part of the period T) as opposed to spanning the entire period. Therefore, a smaller number of feature functions are required to be calculated for each photon detection compared to the corresponding sinusoidal feature function which may reduce computational requirements on the device. The number of spline functions returning feature values for each photon detection is one more than the order of the polynomial used (for example, for the linear function, two spline functions return a feature value for a photon detection and for the quadratic function, three spline functions return a feature value per photon detection). The basis functions depicted in Figure 12 are such that two or more of the basis set of spline functions return a non-zero value per photon detection event across the time window T.

In addition, the set of spline functions can be used to represent the constant function (see the upper most function on the right hand side of Figure 12(a) and 12(b), labelled by reference 1008a and 1008b respectively). By generating the constant function, the compressed representation formed using spline functions has the ability to distinguish signal information from background information in the compressed representation in the same manner compared to a compressed representation using a set of sinusoidal functions.

A skilled person will appreciate that variations of the enclosed arrangement are possible without departing from the invention. Accordingly, the above description of the specific embodiments are made by way of example only and not for the purposes of limitations. It will be clear to the skilled person that minor modifications may be made without significant changes to the operation described.

The project leading to this application has received funding from the European Research Council (ERC) under the European Union's Horizon 2020 research and innovation programme (grant agreement No 694888).

**Claims**

**1.** A sensor device for photon-based imaging comprising:

one or more photon detectors (22) configured to produce a plurality of photon detection signals in response to a plurality of photon detection events, wherein each photon detection event has a corresponding detection time and wherein the detection times of the plurality of photon detection events are distributed in accordance with a distribution over time, wherein the photon detection events correspond to detection of photons produced by an illumination source associated with the sensor device and subsequently scattered and/or reflected and/or transmitted over a detection time period;

processing circuitry (24) associated with the one or more photon detectors configured to obtain timing information of the plurality of photon detection events; and

further processing circuitry (26) configured to and to perform a sketching process using the timing information of the plurality of photon detection events to obtain a compressed representation of the distribution over time, wherein the sketching process comprises:

generating a plurality of feature values based on the timing information of the plurality of photon detection events using one or more feature functions;

combining the generated plurality of feature values to obtain the compressed representation of the distribution over time, wherein

the feature functions have one or more properties such that combining the plurality of feature values generated using the one or more feature functions preserves signal information and/or supresses background information and/or distinguishes signal information from background information in the compressed representation,

wherein the compressed representation is such that at least one or more desired parameters of the distribution over time can be estimated by performing a parameter estimation process using the compressed representation, wherein the parameter estimation process is based on a model of the distribution over time,

wherein the one or more feature functions are dependent on at least time and are continuous.

2. The device according to claim 1, wherein each photon detector comprises a single photon avalanche diode (SPAD).

3. The device according to any preceding claim, wherein the one or more feature functions are based on an expected background distribution of the photon detection events and/or wherein the one or more feature functions comprise a functional form such that, when combining the feature values, the feature values associated with background photon detection events substantially cancel to provide a zero or at least substantially supressed contribution to the compressed representation.

4. The device as claimed in any preceding claim, wherein the one or more feature functions comprise at least one of a), b), c), d):

a) a mapping of timing information to a phase representation so that the feature values are representative of a phase, such that, when the feature values are combined, the phases for background events substantially cancel
b) at least one of a non-linear function, a periodic function;
c) at least one of: periodic triangle functions, harmonic periodic functions, periodic complex representations;
d) at least one of: a polynomial function; a piecewise polynomial function; a spline function.

5. The device according to any preceding claims, wherein the one or more feature functions produce non-zero valued feature values and/or wherein combining the feature values uses feature values obtained from each of the plurality of photon detection events.

6. The device according to any preceding claim, wherein the photon detection events occur over a pre-determined detection time period and wherein the one or more feature functions comprises a periodic function **characterised by** a frequency that is a multiple of the inverse of the pre-determined detection time period.

7. The device according to claim 6, wherein the sketching process comprises selecting more than one frequency for the one or more feature functions in accordance with a frequency-selection scheme and wherein the sketching process further comprises generating feature values and combining said feature values for each selected frequency, optionally wherein the selection of the frequency is such that combining feature values generated by the sketching function at each of the selected frequencies suppresses the background information.

8. The device according to claim 6 or 7, wherein at least one of a), b) and c):

a) the frequencies are selected in accordance with a random distribution
b) a first pre-determined number of frequencies from a set of frequencies are selected;
c) a frequency equal to zero is selected to provide information related to the number of photon detection events.

9. The device according to any preceding claim wherein the feature functions comprise or are configured to be formed from a set of basis functions, and wherein at least one a), b) and c):

a) the set of basis functions comprise a set of polynomial basis functions that are combinable to form an approximation of a sinusoidal function or other periodic, non-linear function;
b) each basis function comprises a local portion centred on or associated with a respective time and the local portion of each basis function overlaps in time with one or more local portions of the other basis functions and/or the local portion comprises a polynomial function;
c) at least two basis functions of the set of basis functions are non-zero over at least part of, optionally, all of a time window.

10. The device according to any preceding claim wherein the timing information comprises at least one of a) and b):

a) a representation of the detection time of each photon detection event signal;
b) a count of photon detection events in one or more pre-determined timing intervals.

11. The device according to any preceding claim wherein at least one of a), b), c):

a) wherein each photon detection event signal comprises time data representative of the detection time at which the photon detection event occurred.
b) combining the plurality of the feature values comprises storing a running total or average of the feature values and updating the running total or average using a new feature value in response to a photon detection event;
c) the model of the distribution over time comprise at least a portion that is dependent on intensity of the received light.

12. The device as claimed in any preceding claim, wherein the device comprises a memory resource for storing the compressed representation and/or a communication interface for communication of the compressed representation to a further device, optionally wherein the processing circuitry is further configured to perform the parameter estimation process on the compressed representation thereby to determine an estimate for the one or more desired parameters, and wherein the communication resource is for communicating the determined estimates to a further computing resource.

13. The device according to any preceding claim, wherein at least one of:

a) the one or more desired parameters comprise a measure of distance between the sensor device and a target in a scene and/or a measure of intensity of reflection of light by a target;
b) the one or more parameters are estimated from the compressed representation by performing a mathematical optimization process using the compressed representation;
c) obtaining the feature values comprises retrieving a value from a look-up table and/or performing a feature value generating algorithm, for example, digit-by-digit algorithm or CORDIC algorithm.

14. An imaging system comprising the sensor device as claimed in any of claims 1 to 13 and the illumination source.

15. A method comprising:

performing a sketching process using timing information of a plurality of photon detection events, wherein each photon detection event has a corresponding detection time and wherein the detection times of the plurality of photon detection events are distributed in accordance with a distribution over time, to obtain a compressed representation of the distribution over time, wherein the photon detection events correspond to detection of photons produced by an illumination source associated with the sensor device and subsequently scattered and/or reflected and/or transmitted over a detection time period and wherein the sketching process comprises:

obtaining timing information of the plurality of photon detection events;
generating a plurality of feature values based on the timing information of the plurality of photon detection events using one or more feature functions;
combining the generated plurality of feature values to obtain the compressed representation of the distribution over time, wherein
the one or more feature functions have one or more properties such that combining the plurality of feature values generated using the one or more feature functions preserves signal information and/or supresses background information and/or distinguishes signal information from background information in the compressed representation,

wherein the compressed representation is such that at least one or more desired parameters of the distribution over time can be estimated by performing a parameter estimation process using the compressed representation, wherein the parameter estimation process is based on a model of the distribution over time, wherein the one or more feature functions are dependent on at least time and are continuous.

## Patentansprüche

1. Sensorvorrichtung für photonenbasierte Bildgebung, umfassend:

   einen oder mehrere Photonendetektoren (22), die so konfiguriert sind, dass sie in Reaktion auf eine Vielzahl von Photonendetektionsereignissen eine Vielzahl von Photonendetektionssignalen erzeugen, wobei jedes Photonendetektionsereignis eine entsprechende Detektionszeit aufweist, und wobei die Detektionszeiten der Vielzahl von Photonendetektionsereignissen gemäß einer Verteilung über die Zeit verteilt sind, wobei die Photonendetektionsereignisse der Detektion von Photonen, die von einer der Sensorvorrichtung zugeordneten Beleuchtungsquelle erzeugt und anschließend gestreut und/oder reflektiert und/oder transmittiert werden, über einen Detektionszeitraum entsprechen;
   dem einen oder den mehreren Photonendetektoren zugeordnete Verarbeitungsschaltung (24), die so konfiguriert ist, dass sie Zeitinformationen der Vielzahl von Photonendetektionsereignissen erhält; und
   eine weitere Verarbeitungsschaltung (26), die so konfiguriert ist, dass sie unter Verwendung der Zeitinformationen der Vielzahl von Photonendetektionsereignissen einen Skizzierprozess durchführt, um eine komprimierte Darstellung der Verteilung über die Zeit zu erhalten, wobei der Skizzierprozess umfasst:

   Generieren einer Vielzahl von Merkmalswerten auf Basis der Zeitinformationen der Vielzahl von Photonendetektionsereignissen unter Verwendung einer oder mehrerer Merkmalsfunktionen;
   Kombinieren der generierten Vielzahl von Merkmalswerten, um die komprimierte Darstellung der Verteilung über die Zeit zu erhalten, wobei
   die Merkmalsfunktionen eine oder mehrere Eigenschaften aufweisen, sodass das Kombinieren der Vielzahl von Merkmalswerten, die unter Verwendung der einen oder mehreren Merkmalsfunktionen generiert wurden, in der komprimierten Darstellung Signalinformationen beibehält und/oder Hintergrundinformationen unterdrückt und/oder Signalinformationen von Hintergrundinformationen unterscheidet,
   wobei die komprimierte Darstellung so beschaffen ist, dass mindestens ein oder mehrere gewünschte Parameter der Verteilung über die Zeit durch Durchführen eines Parameterschätzprozesses unter Verwendung der komprimierten Darstellung geschätzt werden können, wobei der Parameterschätzprozess auf einem Modell der Verteilung über die Zeit basiert,
   wobei die eine oder mehreren Merkmalsfunktionen von mindestens der Zeit abhängen und stetig sind.

2. Vorrichtung nach Anspruch 1, wobei jeder Photonendetektor eine Einzelphotonen-Lawinendiode (SPAD) umfasst.

3. Vorrichtung nach einem vorstehenden Anspruch, wobei die eine oder mehreren Merkmalsfunktionen auf einer erwarteten Hintergrundverteilung der Photonendetektionsereignisse basieren, und/oder wobei die eine oder die mehreren Merkmalsfunktionen eine funktionale Form umfassen, sodass sich beim Kombinieren der Merkmalswerte die Merkmalswerte, die Hintergrundphotonendetektionsereignissen zugeordnet sind, im Wesentlichen aufheben, um einen Beitrag von null oder mindestens im Wesentlichen unterdrückten Beitrag zu der komprimierten Darstellung bereitzustellen.

4. Vorrichtung nach einem vorstehenden Anspruch, wobei die eine oder mehreren Merkmalsfunktionen mindestens eines von a), b), c), d) umfassen:

   a) eine Abbildung von Zeitinformationen auf eine Phasendarstellung, sodass die Merkmalswerte für eine Phase repräsentativ sind, sodass sich beim Kombinieren der Merkmalswerte die Phasen für Hintergrundereignisse im Wesentlichen aufheben,
   b) mindestens eine von einer nichtlinearen Funktion, einer periodischen Funktion;
   c) mindestens eines von: periodischen Dreiecksfunktionen, harmonischen periodischen Funktionen, periodischen komplexen Darstellungen;
   d) mindestens eine von: einer Polynomfunktion; einer stückweisen Polynomfunktion; einer Spline-Funktion.

5. Vorrichtung nach einem der vorstehenden Ansprüche, wobei die eine oder mehreren Merkmalsfunktionen Merkmalswerte ungleich null erzeugen, und/oder wobei das Kombinieren der Merkmalswerte Merkmalswerte verwendet, die aus jedem der Vielzahl von Photonendetektionsereignisse erhalten wurden.

6. Vorrichtung nach einem vorstehenden Anspruch, wobei die Photonendetektionsereignisse über einen vorbestimmten Detektionszeitraum stattfinden, und wobei die eine oder mehreren Merkmalsfunktionen eine periodische Funktion umfassen, die durch eine Frequenz gekennzeichnet ist, die ein Vielfaches des Kehrwerts des vorbestimmten Detektionszeitraums ist.

7. Vorrichtung nach Anspruch 6, wobei der Skizzierprozess das Auswählen von mehr als einer Frequenz für die eine oder mehreren Merkmalsfunktionen gemäß einem Frequenzauswahlschema umfasst, und wobei der Skizzierprozess weiter das Generieren von Merkmalswerten und das Kombinieren der Merkmalswerte für jede ausgewählte Frequenz umfasst, gegebenenfalls wobei die Auswahl der Frequenz so beschaffen ist, dass Kombinieren von Merkmalswerten, die durch die Skizzierfunktion generiert wurden, bei jeder der ausgewählten Frequenzen die Hintergrundinformationen unterdrückt.

8. Vorrichtung nach Anspruch 6 oder 7, wobei mindestens eines von a), b) und c) zutrifft:

a) die Frequenzen werden gemäß einer Zufallsverteilung ausgewählt;
b) es wird eine erste vorbestimmte Anzahl von Frequenzen aus einer Menge von Frequenzen ausgewählt;
c) es wird eine Frequenz gleich null ausgewählt, um Informationen bezüglich der Anzahl von Photonendetektionsereignissen bereitzustellen.

9. Vorrichtung nach einem vorstehenden Anspruch, wobei die Merkmalsfunktionen eine Menge von Basisfunktionen umfassen oder so konfiguriert sind, dass sie aus einer Menge von Basisfunktionen gebildet werden, und wobei mindestens ein a), b) und c) zutrifft:

a) die Menge von Basisfunktionen umfasst eine Menge von Polynom-Basisfunktionen, die kombiniert werden können, um eine Näherung einer Sinusfunktion oder einer anderen periodischen, nichtlinearen Funktion zu bilden;
b) jede Basisfunktion umfasst einen lokalen Abschnitt, der auf einer jeweiligen Zeit zentriert oder einer jeweiligen Zeit zugeordnet ist, und der lokale Abschnitt jeder Basisfunktion überlappt sich zeitlich mit einem oder mehreren lokalen Abschnitten der anderen Basisfunktionen und/oder der lokale Abschnitt umfasst eine Polynomfunktion;
c) mindestens zwei Basisfunktionen der Menge von Basisfunktionen sind über mindestens einen Teil eines Zeitfensters, gegebenenfalls über ein gesamtes Zeitfenster, ungleich null.

10. Vorrichtung nach einem vorstehenden Anspruch, wobei die Zeitinformationen mindestens eines von a) und b) umfassen:

a) eine Darstellung der Detektionszeit jedes Photonendetektionsereignissignals;
b) eine Anzahl von Photonendetektionsereignissen in einem oder mehreren vorbestimmten Zeitintervallen.

11. Vorrichtung nach einem vorstehenden Anspruch, wobei mindestens eines von a), b), c) zutrifft:

a) wobei jedes Photonendetektionsereignissignal Zeitdaten umfasst, die für die Detektionszeit, zu der das Photonendetektionsereignis stattfand, repräsentativ sind;
b) das Kombinieren der Vielzahl der Merkmalswerte umfasst das Speichern einer laufenden Summe oder eines Durchschnitts der Merkmalswerte und das Aktualisieren der laufenden Summe oder des Durchschnitts unter Verwendung eines neuen Merkmalswertes in Reaktion auf ein Photonendetektionsereignis;
c) das Modell der Verteilung über die Zeit umfasst mindestens einen Abschnitt, der von der Intensität des empfangenen Lichts abhängt.

12. Vorrichtung nach einem vorstehenden Anspruch, wobei die Vorrichtung eine Speicherressource zum Speichern der komprimierten Darstellung und/oder eine Kommunikationsschnittstelle zur Kommunikation der komprimierten Darstellung an eine weitere Vorrichtung umfasst, gegebenenfalls wobei die Verarbeitungsschaltung weiter so konfiguriert ist, dass sie den Parameterschätzprozess an der komprimierten Darstellung durchführt, um dadurch eine Schätzung für den einen oder die mehreren gewünschten Parameter zu bestimmen, und wobei die Kommunikationsressource zum Kommunizieren der bestimmten Schätzungen an eine weitere Rechenressource dient.

**13.** Vorrichtung nach einem vorstehenden Anspruch, wobei mindestens eines der Folgenden zutrifft:

a) der eine oder die mehreren gewünschten Parameter umfassen ein Maß für den Abstand zwischen der Sensorvorrichtung und einem Ziel in einer Szene und/oder ein Maß für die Intensität der Lichtreflexion durch ein Ziel;

b) der eine oder die mehreren Parameter werden anhand der komprimierten Darstellung durch Durchführen eines mathematischen Optimierungsprozesses unter Verwendung der komprimierten Darstellung geschätzt;

c) Erhalten der Merkmalswerte umfasst das Abrufen eines Wertes aus einer Nachschlagetabelle und/oder Durchführen eines Merkmalswertgenerierungsalgorithmus, zum Beispiel Ziffer-für-Ziffer-Algorithmus oder CORDIC-Algorithmus.

**14.** Bildgebungssystem, das die Sensorvorrichtung nach einem der Ansprüche 1 bis 13 und die Beleuchtungsquelle umfasst.

**15.** Verfahren, umfassend:

Durchführen eines Skizzierprozesses unter Verwendung von Zeitinformationen einer Vielzahl von Photonendetektionsereignissen, wobei jedes Photonendetektionsereignis eine entsprechende Detektionszeit aufweist, und wobei die Detektionszeiten der Vielzahl von Photonendetektionsereignissen gemäß einer Verteilung über die Zeit verteilt sind, um eine komprimierte Darstellung der Verteilung über die Zeit zu erhalten, wobei die Photonendetektionsereignisse der Detektion von Photonen, die von einer der Sensorvorrichtung zugeordneten Beleuchtungsquelle erzeugt und anschließend gestreut und/oder reflektiert und/oder transmittiert werden, über einen Detektionszeitraum entsprechen, und wobei der Skizzierprozess umfasst:

Erhalten von Zeitinformationen der Vielzahl von Photonendetektionsereignissen;

Generieren einer Vielzahl von Merkmalswerten auf Basis der Zeitinformationen der Vielzahl von Photonendetektionsereignissen unter Verwendung einer oder mehrerer Merkmalsfunktionen;

Kombinieren der generierten Vielzahl von Merkmalswerten, um die komprimierte Darstellung der Verteilung über die Zeit zu erhalten, wobei

die eine oder mehreren Merkmalsfunktionen eine oder mehrere Eigenschaften aufweisen, sodass das Kombinieren der Vielzahl von Merkmalswerten, die unter Verwendung der einen oder mehreren Merkmalsfunktionen generiert wurden, **in** der komprimierten Darstellung Signalinformationen beibehält und/oder Hintergrundinformationen unterdrückt und/oder Signalinformationen von Hintergrundinformationen unterscheidet,

wobei die komprimierte Darstellung so beschaffen ist, dass mindestens ein oder mehrere gewünschte Parameter der Verteilung über die Zeit durch Durchführen eines Parameterschätzprozesses unter Verwendung der komprimierten Darstellung geschätzt werden können, wobei der Parameterschätzprozess auf einem Modell der Verteilung über die Zeit basiert, wobei die eine oder mehreren Merkmalsfunktionen von mindestens der Zeit abhängen und stetig sind.

**Revendications**

**1.** Dispositif de capteur pour l'imagerie photonique comprenant :

un ou plusieurs détecteurs de photons (22) configurés pour produire une pluralité de signaux de détection de photons en réponse à une pluralité d'événements de détection de photons, dans lequel chaque événement de détection de photons présente un temps de détection correspondant et dans lequel les temps de détection de la pluralité d'événements de détection de photons sont distribués conformément à une distribution au fil du temps, dans lequel les événements de détection de photons correspondent à la détection de photons produits par une source d'éclairage associée au dispositif de capteur et ultérieurement dispersés et/ou reflétés et/ou transmis sur une période de détection ;

des circuits de traitement (24) associés à l'un ou aux plusieurs détecteurs de photons configurés pour obtenir des informations temporelles sur la pluralité d'événements de détection de photons ; et

des circuits de traitement supplémentaires (26) configurés pour réaliser un processus d'esquisse utilisant les informations temporelles de la pluralité d'événements de détection de photons pour obtenir une représentation compressée de la distribution au fil du temps, dans lequel le processus d'esquisse comprend :

la génération d'une pluralité de valeurs caractéristiques basées sur les informations temporelles de la pluralité d'événements de détection de photons utilisant une ou plusieurs fonctions caractéristiques ;

la combinaison de la pluralité de valeurs caractéristiques générées pour obtenir la représentation compressée de la distribution au fil du temps, dans lequel

les fonctions caractéristiques présentent une ou plusieurs propriétés telles que la combinaison de la pluralité de valeurs caractéristiques générées utilisant l'une ou les plusieurs fonctions caractéristiques préserve des informations de signal et/ou supprime des informations de fond et/ou distingue des informations de signal d'informations de fond dans la représentation compressée,

dans lequel la représentation compressée est telle qu'au moins un ou plusieurs paramètres souhaités de la distribution au fil du temps peuvent être estimés en réalisant un processus d'estimation de paramètre utilisant la représentation compressée, dans lequel le processus d'estimation de paramètre est basé sur un modèle de la distribution au fil du temps,

dans lequel l'une ou les plusieurs fonctions caractéristiques dépendent au moins du temps et sont continues.

2. Dispositif selon la revendication 1, dans lequel chaque détecteur de photons comprend une diode à avalanche à photon unique (SPAD).

3. Dispositif selon une quelconque revendication précédente, dans lequel l'une ou les plusieurs fonctions caractéristiques sont basées sur une distribution de fond attendue des événements de détection de photons et/ou dans lequel l'une ou les plusieurs fonctions caractéristiques comprennent une forme fonctionnelle telle que, lors de la combinaison des valeurs caractéristiques, les valeurs caractéristiques associées à des événements de détection de photons de fond s'annulent sensiblement pour fournir une contribution nulle ou au moins sensiblement supprimée à la représentation compressée.

4. Dispositif selon une quelconque revendication précédente, dans lequel l'une ou les plusieurs fonctions caractéristiques comprennent au moins une parmi a), b), c), d) :

a) une cartographie d'informations temporelles avec une représentation de phase, de sorte que les valeurs caractéristiques sont représentatives d'une phase, de sorte que, lorsque les valeurs caractéristiques sont combinées, les phases d'événements de fond s'annulent sensiblement

b) au moins une parmi une fonction non linéaire, une fonction périodique ;

c) au moins une parmi : des fonctions triangulaires périodiques, des fonctions harmoniques périodiques, des représentations complexes périodiques ;

d) au moins une parmi : une fonction polynomiale ; une fonction polynomiale par morceaux ; une fonction spline.

5. Dispositif selon l'une quelconque des revendications précédentes, dans lequel l'une ou les plusieurs fonctions caractéristiques produisent des valeurs caractéristiques non nulles et/ou dans lequel la combinaison des valeurs caractéristiques utilise des valeurs caractéristiques obtenues à partir de chacun de la pluralité d'événements de détection de photons.

6. Dispositif selon une quelconque revendication précédente, dans lequel les événements de détection de photons se produisent sur une période de détection prédéterminée et dans lequel l'une ou les plusieurs fonctions caractéristiques comprennent une fonction périodique **caractérisée par** une fréquence qui est un multiple de l'inverse de la période de détection prédéterminée.

7. Dispositif selon la revendication 6, dans lequel le processus d'esquisse comprend la sélection de plus d'une fréquence pour l'une ou les plusieurs fonctions caractéristiques conformément à un schéma de sélection de fréquence et dans lequel le processus d'esquisse comprend en outre la génération de valeurs caractéristiques et la combinaison desdites valeurs caractéristiques pour chaque fréquence sélectionnée, facultativement dans lequel la sélection de la fréquence est telle que la combinaison de valeurs caractéristiques générées par la fonction d'esquisse à chacune des fréquences sélectionnées supprime les informations de fond.

8. Dispositif selon la revendication 6 ou 7, dans lequel au moins un parmi a), b) et c) :

a) les fréquences sont sélectionnées conformément à une distribution aléatoire

b) un premier nombre prédéterminé de fréquences parmi un ensemble de fréquences est sélectionné ;

c) une fréquence égale à zéro est sélectionnée pour fournir des informations relatives au nombre d'événements de détection de photons.

9. Dispositif selon une quelconque revendication précédente, dans lequel les fonctions caractéristiques comprennent ou sont configurées pour être formées à partir d'un ensemble de fonctions de base, et dans lequel au moins un parmi a), b) et c) :

a) l'ensemble de fonctions de base comprend un ensemble de fonctions de base polynomiales qui peuvent être combinées pour former une approximation d'une fonction sinusoïdale ou d'une autre fonction périodique non linéaire ;
b) chaque fonction de base comprend une portion locale centrée sur ou associée à un temps respectif et la portion locale de chaque fonction de base chevauche temporellement une ou plusieurs portions locales des autres fonctions de base et/ou la portion locale comprend une fonction polynomiale ;
c) au moins deux fonctions de base de l'ensemble de fonctions de base sont non nulles sur au moins une partie, facultativement la totalité, d'une fenêtre temporelle.

10. Dispositif selon une quelconque revendication précédente, dans lequel les informations temporelles comprennent au moins un parmi a) et b) :

a) une représentation du temps de détection de chaque signal d'événement de détection de photons ;
b) un compte d'événements de détection de photons dans un ou plusieurs intervalles de temps prédéterminés.

11. Dispositif selon une quelconque revendication précédente, dans lequel au moins un parmi : a), b), c) :

a) dans lequel chaque signal d'événement de détection de photons comprend des données temporelles représentatives du temps de détection auquel l'événement de détection de photon s'est produit ;
b) la combinaison de la pluralité des valeurs caractéristiques comprend le stockage d'un total cumulé ou d'une moyenne des valeurs caractéristiques et la mise à jour du total cumulé ou de la moyenne utilisant une nouvelle valeur caractéristique en réponse à un événement de détection de photons ;
c) le modèle de la distribution au fil du temps comprend au moins une portion qui dépend de l'intensité de la lumière reçue.

12. Dispositif selon une quelconque revendication précédente, dans lequel le dispositif comprend une ressource de mémoire pour stocker la représentation compressée et/ou une interface de communication pour la communication de la représentation compressée à un dispositif supplémentaire, facultativement dans lequel les circuits de traitement sont en outre configuré pour réaliser le processus d'estimation de paramètre sur la représentation compressée pour ainsi déterminer une estimation pour l'un ou les plusieurs paramètres souhaités, et dans lequel la ressource de communication sert à communiquer les estimations déterminées à une ressource informatique supplémentaire.

13. Dispositif selon une quelconque revendication précédente, dans lequel au moins un parmi :

a) l'un ou les plusieurs paramètres souhaités comprennent une mesure de distance entre le dispositif de détection et une cible dans une scène et/ou une mesure d'intensité de réflexion de lumière par une cible ;
b) l'un ou les plusieurs paramètres sont estimés à partir de la représentation compressée en réalisant un processus d'optimisation mathématique utilisant la représentation compressée ;
c) l'obtention des valeurs caractéristiques comprend la récupération d'une valeur à partir d'une table de consultation et/ou la réalisation d'un algorithme de génération de valeurs caractéristiques, par exemple, algorithme chiffre par chiffre ou algorithme CORDIC.

14. Système d'imagerie comprenant le dispositif de capteur selon l'une quelconque des revendications 1 à 13 et la source d'éclairage.

15. Procédé comprenant :

la réalisation d'un processus d'esquisse utilisant des informations temporelles parmi une pluralité d'événements de détection de photons, dans lequel chaque événement de détection de photons présente un temps de détection correspondant et dans lequel les temps de détection de la pluralité d'événements de détection de photons sont distribués conformément à une distribution au fil du temps pour obtenir une représentation compressée de la distribution au fil du temps, dans lequel les événements de détection de photons correspondent à la détection de photons produits par une source d'éclairage associée au dispositif de capteur et ultérieurement diffusés et/ou reflétés et/ou transmis sur une période de détection et dans lequel le processus d'esquisse comprend :

l'obtention d'informations temporelles de la pluralité d'événements de détection de photons ;

la génération d'une pluralité de valeurs caractéristiques basées sur les informations temporelles de la pluralité d'événements de détection de photons utilisant une ou plusieurs fonctions caractéristiques ;

la combinaison de la pluralité de valeurs caractéristiques générées pour obtenir la représentation compressée de la distribution au fil du temps, dans lequel

l'un ou les plusieurs fonctions caractéristiques présentent une ou plusieurs propriétés telles que la combinaison de la pluralité de valeurs caractéristiques générées utilisant l'une ou les plusieurs fonctions caractéristiques préserve des informations de signal et/ou supprime des informations de fond et/ou distingue des informations de signal d'informations de fond dans la représentation compressée,

dans lequel la représentation compressée est telle qu'au moins un ou plusieurs paramètres souhaités de la distribution au fil du temps peuvent être estimés en réalisant un processus d'estimation de paramètre utilisant la représentation compressée, dans lequel le processus d'estimation de paramètre est basé sur un modèle de la distribution au fil du temps, dans lequel l'une ou les plusieurs fonctions caractéristiques dépendent au moins du temps et sont continues.

Sensor
Device 10

Illumination
Source 12

Targets 16

Scene 14

Figure 1

| SPAD 22 | Time-Stamp Processing Circuitry (TDC) 24 | Processing Circuitry 26 | Storage 28 |
|---|---|---|---|

Pixel 20a

Pixel 20b

•
•
•

Pixel 20n

Communication Resource

<u>30</u>

Sensor device 110

Figure 2

Non-Linear Feature
Function
(Multivariate)

Photon Detection Times

$t_n$ — — $t_3$ $t_2$ $t_1$

302

$\Phi(t_1)$

304

Detection Time
Feature Vector

Feature Vector 1

306

Summation/Aggregation

Current Sketch

Updated Sketch

308

Figure 3

400

| Illuminate object in scene | 402 |

For every photon detection
event over detection period — 404

Produce a photon detection signal — 406

414

Process photon detection signal to
obtain photon detection event signals — 408

Obtain feature values using photon
detection event signals — 410

Combine feature values to update
intermidiate compressed representation — 412

Transfer compressed representation — 416

Use final compressed representation to
determine a distance parameter — 418

Figure 4

| SPAD | Processing Circuitry | | Storage |
| 122 | 126 | | 128 |

Pixel 120a

Pixel 120b

Pixel 120n

| Communication Resource | Signal Generators |
| 130 | 132 |

Sensor device 110

Figure 5

Figure 6

Figure 7

Figure 8(a)

Figure 8(b)

Figure 9(a)

Figure 9(b)

Figure 10

**Sketched Lidar**

RMSE = 10.63

Compression = 0.0059
a) Real Measurements = 2 (m = 1)

RMSE = 8.01

Compression = 0.0237
c) Real Measurements = 8 (m = 4)

RMSE = 7.40

Compression = 0.0593
e) Real Measurements = 20 (m = 10)

**Coarse Binning**

RMSE = 1430.1

Compression = 0.0059
b) Measurements = 2

RMSE = 201.6

Compression = 0.0237
d) Measurements = 8

RMSE = 100.9

Compression = 0.0593
f) Measurements = 20

**Log Matched Filter**
RMSE = 6.87

g) No Compression

**Ground Truth**

h)

150    300    450    600
Intensity

## Figure 11(a)

Sketched Lidar  |  Coarse Binning

Compression = 0.0261
a) Real Measurements = 4 (m = 2)

Compression = 0.0261
b) Measurements = 4

Compression = 0.0915
c) Real Measurements = 14 (m = 7)

Compression = 0.0915
d) Measurements = 14

Compression = 0.1307
e) Real Measurements = 20 (m = 10)

Compression = 0.1307
f) Measurements = 20

Expectation Maximization

g) No Compression

Intensity

Figure 11(b)

Figure 12(a)

Figure 12(b)

**EP 4 285 145 B1**

## REFERENCES CITED IN THE DESCRIPTION

### Patent documents cited in the description

- JP 2016161438 A
- US 2018209846 A